# FASCICULE DE BREVET EUROPEEN

(11) **EP 3 024 963 B1**
(45) Date de publication et mention de la délivrance du brevet: **30.08.2017**
(21) Numéro de dépôt: 14759013.7
(22) Date de dépôt: 23.07.2014
(51) Int. Cl.: C30B 29/16, G02F 1/09, G02B 27/28, C30B 9/04

(54) **PROCEDE DE PREPARATION DE SESQUIOXYDES CUBIQUES MONOCRISTALLINS**
VERFAHREN ZUR HERSTELLUNG VON KUBISCHEN EINKRISTALL-SESQUIOXIDEN
METHOD FOR PREPARING SINGLE-CRYSTAL CUBIC SESQUIOXIDES

(30) Priorité: 24.07.2013 FR 1357308
(43) Date de publication de la demande: 01.06.2016
(73) Titulaire: Centre National de la Recherche Scientifique (C.N.R.S.), 75016 Paris (FR)
(72) Inventeur: VEBER, Philippe, F-33800 Bordeaux (FR); VELAZQUEZ, Matias, F-33600 Pessac (FR); VIRAPHONG, Oudomsack, F-33400 Talence (FR); BUSE, Gabriel, F-33000 Bordeaux (FR)
(74) Mandataire: Goulard, Sophie
(86) Numéro de dépôt international: PCT/FR2014/051912
(87) Numéro de publication internationale: WO 2015/011416

(56) Documents cités:
- WO-A1-2012/150037
- FR-A1- 2 952 074
- US-A1- 2011 133 111
- GOURISHANKAR K V ET AL: "Thermodynamics of mixed oxide compounds, Li2O Ã Â Ln2O3 (Ln=Nd or Ce)", METALLURGICAL AND MATERIALS TRANSACTIONS B, vol. 28, no. 6, 1 décembre 1997 (1997-12-01), pages 1103-1110, XP019696757, SPRINGER-VERLAG, NEW YORK ISSN: 1543-1916
- PHILIPPE VEBER, MATIAS VELAZQUEZ, VERONIQUE JUBERA, STANISLAV PECHEV AND OUDOMSACK VIRAPHONG: "Flux growth of Yb+3 doped Re2O3 (Re=Y,Lu) single crystals at half their melting point temperature", CRYSTENGCOMM, vol. 13, 15 juin 2011 (2011-06-15), pages 5220-5225, XP002722901,
- P. PESCHEV, S. PECHEV, V. NIKOLOV, P. GRAVEREAU, JP. CHAMINADE, D. BINEV AND D. IVANOVA: "Studies on some ternary oxyborates of the Na2O-Me2O3-B2O2 (Me=rare earth or aluminum) Systems: Synthesis, structure and crystal growth", JOURNAL OF SOLID STATE CHEMISTRY, vol. 179, 27 janvier 2006 (2006-01-27), pages 2834-2849, XP002722902,

## Description

La présente invention est relative à un procédé de préparation de monocristaux massifs ou en couches minces de sesquioxydes cubiques (groupe d'espace n°206, Ia-3) de scandium, d'yttrium ou de terres rares dopés ou non par des ions lanthanides de valence +III, par une technique de croissance en flux à haute température, et aux diverses applications des monocristaux obtenus selon ce procédé, notamment dans le domaine de l'optique.

Les sesquioxydes cubiques purs, c'est-à-dire non dopés, sont des cristaux qui peuvent être utilisés à titre de cristal rotateur dans les isolateurs de Faraday qui sont composés de quatre constituants : un polariseur d'entrée, un cristal rotateur, un aimant permanent et un polariseur de sortie. En effet, le développement et l'amélioration des technologies laser ont entraîné un besoin en composants optiques qui protègent la cavité laser des réflexions en retour. Les isolateurs Faraday permettent efficacement de supprimer les instabilités et les fluctuations d'intensité dans les systèmes laser. Ils peuvent servir à protéger la cavité dans les lasers à gaz ou à solide, ainsi que les diodes laser de plus en plus puissantes, des réflexions en retour, comme mentionné ci-dessus, mais aussi à empêcher les oscillations parasites dans les amplificateurs lasers à solide à plusieurs étages. Les isolateurs Faraday sont des composants optiques qui permettent à la lumière de circuler dans une seule direction. Leur mode de fonctionnement est basé sur l'effet Faraday, effet qui procède en transmission et qui est linéaire en induction magnétique et en longueur d'onde. Pour la plupart des longueurs d'onde, le cristal rotateur est un grenat de gallium et de terbium (« *Terbium Gallium Garnet* » : TGG), placé dans un champ magnétique élevé et homogène. C'est dans ce dernier que la polarisation du rayon lumineux tourne, selon un angle dit « de Faraday », proportionnellement à la constante de Verdet, à la distance parcourue dans le cristal rotateur et à l'induction électromagnétique. En général, ces trois paramètres sont ajustés de manière à ce que la polarisation de sortie soit tournée de 45°. Si un rayon lumineux de polarisation quelconque vient dans la direction opposée, alors sa polarisation est tournée dans le même sens : c'est le caractère non réciproque de l'effet Faraday, qui permet notamment d'isoler les cavités laser fortes puissances. L'isolation maximale de l'isolateur Faraday est cependant limitée par les inhomogénéités dans le cristal TGG et l'induction électromagnétique. Il existe donc un besoin pour des sesquioxydes cubiques monocristallins qui puissent avantageusement être utilisés à titre de cristal rotateur dans un isolateur Faraday, en particulier qui soient capables d'endurer de fortes puissances en fonctionnement continu.

Les lasers à solide utilisent des milieux solides, tels que des cristaux ou des verres comme milieu d'émission (spontanée et stimulée) des photons et milieu amplificateur. Le milieu amplificateur, ou encore milieu à gain, est constitué d'un matériau optiquement actif comprenant une matrice (le verre ou le cristal) rendue optiquement active par dopage par un ion qui absorbe le rayonnement d'une source de pompage optique et qui se désexcite par émission de photons. Le premier laser est un laser à rubis dont l'émission provient de l'ion Cr³⁺. D'autres ions sont très utilisés : la plupart sont des ions de terres rares : Nd³⁺, Yb³⁺, Pr³⁺, Er³⁺, Tm³⁺, Eu³⁺... ou encore des ions de métaux de transition tels que Ti³⁺, ou Cr³⁺ entre autres. La longueur d'onde d'émission du laser dépend essentiellement de l'ion dopant pour les ions terres rares et des propriétés de la matrice dans tous les cas, l'influence de cette dernière étant beaucoup plus importante dans le cas des ions de métaux de transition. Ainsi, le verre dopé au néodyme n'émet pas à la même longueur d'onde (1053 nm) que le solide cristallin appelé « grenat » d'yttrium et d'aluminium, plus connu sous son acronyme anglais YAG signifiant «*yttrium-aluminium-garnet*»*,* et constitué d'Y₃Al₅O₁₂ dopé au néodyme (1064 nm). Les lasers à solide fonctionnent en régime continu ou en régime impulsionnel (impulsions de quelques microsecondes à quelques femto secondes). Ils sont capables d'émettre aussi bien dans le visible, le proche et le moyen infrarouge que l'ultraviolet.

Au-delà d'une dimension de cristal de qualité optique acceptable, ces lasers permettent d'obtenir des puissances de l'ordre de la dizaine de watts en continu et des puissances plus élevées en pulsé. Ils sont utilisés pour des applications tant scientifiques qu'industrielles comme le soudage, le marquage et la découpe de matériaux.

En plus de leur utilisation dans la fabrication de lasers à forte puissance et/ou à impulsions courtes, ces matériaux solides constitués d'une matrice et d'un ion dopant peuvent également être utilisés dans la fabrication de lasers à sécurité oculaire, de lasers pour la chirurgie et /ou l'ophtalmologie (pompés diodes, impulsionnels ou continus, dans le rouge le vert et jusqu'au moyen infrarouge), de scintillateurs, de guides d'ondes, de bolomètres (détecteurs à discrimination chaleur-lumière), pour le refroidissement optique, comme matériaux luminophores ou bien encore comme matériaux pour le stockage et la manipulation de l'information quantique.

A ce jour, les solides cristallins les plus prometteurs pour l'ensemble de ces applications, et notamment pour la fabrication de lasers, sont des sesquioxydes cubiques (donc isotropes) de formule R₂O₃ dans laquelle R représente un ou plusieurs éléments choisis parmi les métaux de valence III tels que le scandium, l'yttrium et les terres rares (La, Ce, Pr, Nd, Pm, Sm, Eu, Gd, Tb, Dy, Ho, Er, Tm, Yb, Lu), dopés par des ions terre rare. Certains d'entre eux présentent en particulier une conductivité thermique supérieure à celle du YAG dopé ion de terre rare qui est pourtant le matériau laser le plus utilisé actuellement. Ces sesquioxydes cubiques sont également intéressants dans la mesure où ils peuvent être facilement dopés par des ions terre rare et ont une forte masse volumique (de l'ordre de 4 à 9,5 g.cm⁻³ environ). De plus, les sesquioxydes d'yttrium, de scandium, de gadolinium et de lutétium présentent de basses énergies de phonons par rapport à la plupart des oxydes, en particulier du YAG.

Ces matériaux sont principalement obtenus sous forme de céramiques transparentes préparées par frittage haute pression et haute température, de préférence sous vide. Ces céramiques présentent cependant une microstructure polycristalline avec de nombreux joints de grains diminuant les propriétés physiques à la base de leurs applications (diffusion des photons, présence d'impuretés, faible conductivité thermique, taux de dopage limité, etc ...).

Un procédé de synthèse de sesquioxydes cubiques monocristallins visant à remédier aux inconvénients des procédés précédemment connus de l'art antérieur a déjà été proposé dans la demande internationale WO 2011/055075. Le procédé proposé visait notamment à obtenir de façon simple et peu couteuse, des monocristaux de sesquioxydes cubiques de scandium, d'yttrium ou de terre rare dopés aux ions de terre rare présentant, à composition chimique équivalente, une taille supérieure à celle des monocristaux obtenus selon les procédés de l'art antérieur tout en ayant de très bonnes propriétés optiques. Les sesquioxydes préparés selon le procédé décrit dans la demande internationale WO 2011/055075 répondent à la formule suivante R¹₂O₃:R² dans laquelle R¹ est au moins un métal de valence III choisi parmi le scandium, l'yttrium et les éléments de la série des lanthanides, c'est-à-dire parmi les éléments dont le numéro atomique va de 57 (lanthane) à 71 (lutétium) selon la classification périodique des éléments et R² est au moins un élément choisi dans la série des lanthanides. Ce procédé consiste à préparer, un mélange pulvérulent comprenant au moins un soluté constitué d'un mélange mécanique d'au moins un sesquioxyde de formule (R'¹₂O₃)₁₋ₓ en un pourcentage molaire (1-x) et d'au moins un sesquioxyde (R'²₂O₃)ₓ en un pourcentage molaire (x) dans lesquelles R'¹ est identique à R¹, R'² est identique à R² et un solvant de synthèse de formule suivante : [Li₆(R"¹_{1-x'}R"²_{x'})(BO₃)₃] dans laquelle R"¹ et R"² sont respectivement identiques à R¹ et à R² et x' = x puis à porter ledit mélange pulvérulent à une température au moins égale à la température de fusion dudit mélange et ≤ 1250°C, pour entraîner la dissolution du soluté dans le solvant de formule [Li₆(R"¹_{1-x'}R"²_{x'})(BO₃)₃] et obtenir une solution liquide dudit soluté dans ledit solvant ; puis à procéder à la croissance du cristal sur un support solide dans des conditions contrôlées de température.

Bien que ce procédé ait permis de remédier à certains inconvénients engendrés par les procédés de l'art antérieur, notamment en ce qu'il permet d'atteindre des cristaux de taille centimétrique dans leur plus grande longueur, il présente néanmoins encore certains inconvénients. En particulier, le procédé de cristallogenèse est très lent (au moins 40 jours en moyenne) et les cristaux obtenus n'ont néanmoins pas toujours une taille suffisante en raison d'une très forte polynucléation au cours du processus de cristallisation, engendrant une réduction de la taille moyenne de chaque monocristal. Par ailleurs, les cristaux obtenus présentent de nombreuses inclusions de solvant. Ces inclusions viennent limiter le volume utile des cristaux, c'est-à-dire le volume où il n'y a pas d'inclusions, ce qui peut réduire le volume utile à une dimension de 4x2 mm² pour un monocristal ayant initialement après synthèse une taille centimétrique.

La Demanderesse s'est donc fixé pour but d'améliorer encore le procédé décrit dans la demande internationale WO 2011/055075 afin de proposer un procédé permettant d'accéder de façon reproductible et moins lente à des cristaux présentant à la fois une plus grand taille tout en comportant moins d'inclusions de solvant.

La présente invention a pour objet un procédé de préparation d'un monocristal massif ou en couche mince constitué d'une matrice d'un sesquioxyde cubique de scandium, d'yttrium et/ou de terre rare, ladite matrice étant dopée ou non par au moins un élément de la série des lanthanides, ledit monocristal répondant à la formule (I) suivante :

(R¹₁₋ₓR²ₓ)₂O₃ (I)

dans laquelle :
- R¹ est au moins un métal de valence III choisi parmi le scandium, l'yttrium et les éléments de la série des lanthanides, c'est-à-dire parmi les éléments dont le numéro atomique va de 57 (lanthane) à 71 (lutétium) selon la classification périodique des éléments ;
- x est tel que 0 ≤ x < 1
- R² représente au moins un élément choisi dans la série des lanthanides ;
ledit procédé étant caractérisé en ce qu'il est réalisé dans un creuset inerte chimiquement et qu'il comprend les étapes suivantes consistant à :
1) préparer, un mélange pulvérulent (MP1) comprenant au moins :
   - un soluté constitué d'au moins un sesquioxyde de formule (IIa) suivante : R¹₂O₃ (IIa) dans laquelle R¹ représente le même élément que R¹ et, lorsque ladite matrice est dopée par au moins un élément de la série des lanthanides, d'au moins un sesquioxyde de formule (IIb) suivante : R'²₂O₃ (IIb) dans laquelle R'² représente le même élément que R², en un pourcentage molaire (xₚₘ) tel que 0 < xₚₘ ≤ 25 % molaire, étant entendu que ledit sesquioxyde de formule (IIa) est alors présent au sein dudit soluté en un pourcentage molaire (100-xₚₘ), ledit soluté étant présent au sein du mélange MP1 en une quantité z telle que 0 < z ≤ 93 % molaire,
   - un solvant primaire constitué d'un mélange mécanique d'un composé de formule (III) suivante :

      [Li₆(R"¹_{1-x'}R''²_{x'})(BO₃)₃] (III)

      dans laquelle R"¹ et R"² représentent respectivement le même élément que R¹ et R² et x' est tel que 0 ≤ x' < 1,
2) préparer un mélange pulvérulent MP2 comprenant ledit soluté et un solvant de synthèse de formule (IV) suivante :

   [Li₆(R"¹_{1-x'}R''²_{x'})(BO₃)₃] + (Li₂O et/ou B₂O₃ et/ou LiX) (IV)

   dans laquelle R"¹ et R"² représentent respectivement le même élément que R¹ et R², x' est tel que 0 ≤ x' < 1, et X = F, Cl, Br ou I, par ajout au mélange MP1 d'au moins un additif pulvérulent choisi parmi Li₂O, B₂O₃ et LiX avec X = F, Cl, Br ou I, ledit mélange MP1 étant présent au sein du mélange MP2 en une quantité z' telle que 15 ≤ z' < 100 % molaire, ledit additif étant présent au sein du mélange MP2 en une quantité molaire totale s telles que 0 < s ≤ 85 % molaire, et s = 100-z' dans le mélange MP2 ; la quantité molaire z" du soluté au sein du mélange MP2 étant telle que z"=z.z';
3) porter le mélange pulvérulent MP2 obtenu ci-dessus à l'étape 2), à une température T_{MP2} au moins égale à la température de fusion (T_{F}) dudit mélange MP2 et ≤ 1250°C, pour entraîner la dissolution du soluté dans le solvant de synthèse de formule (IV) et obtenir une solution liquide dudit soluté dans le solvant de synthèse de formule (IV) ;
4) maintenir la température de la solution liquide à la température T_{MP2} pendant une durée d'au moins 6 heures, sous agitation au moyen d'un support solide soumis à une rotation autour d'un axe vertical ;
5) refroidir de façon contrôlée la solution liquide depuis la température T_{MP2} jusqu'à une température T_{EXP} comprise entre la température de saturation (Tₛₐₜ) de la solution liquide et la température de sursaturation critique (TC_{Sur}) de la solution liquide ou de la prise en masse de la solution liquide, pour engendrer la cristallisation contrôlée du sesquioxyde de formule (I) attendu sur ledit support solide immergé dans ladite solution liquide et soumis à une rotation autour d'un axe vertical, ledit refroidissement étant opéré à une vitesse maximale de 1°C.h⁻¹ ;
6) retirer le support solide de la solution liquide puis à refroidir de façon contrôlée le sesquioxyde de formule (I) cristallisé sur le support solide depuis la température T_{Exp} jusqu'à la température ambiante, à une vitesse maximale de 50°C.h⁻¹.

Par rapport au procédé décrit dans la demande internationale WO 2011/055075, le procédé conforme à la présente invention, qui met en oeuvre un solvant de synthèse intégrant un composé choisi parmi Li₂O, B₂O₃ et LiX avec X = F, Cl, Br ou I, permet :
- d'accéder de façon plus rapide et reproductible à des monocristaux dopés ou non dopés de plus grande taille et présentant des zones sans inclusions considérablement plus grandes que celles obtenues lorsque le solvant utilisé pour la synthèse ne contient pas un tel additif ;
- d'accéder à des cristaux dans lesquels la matrice comprend du lithium, c'est-à-dire en quantité minime (de l'ordre de quelques ppm à quelques centaines de ppm) et dont la présence a un effet très surprenant sur les propriétés optiques des cristaux de sesquioxydes dopés, c'est-à-dire des cristaux de formule (I) dans lesquels x > 0, dans la mesure où cela conduit à un élargissement inhomogène des bandes d'émissions du dopant, ce qui présente un intérêt lorsque ces cristaux sont utilisés pour des applications laser à impulsions ultracourtes.

En effet, la présence de Li et de B en teneur modérée, de l'ordre de 10¹⁷ à 10¹⁸ atomes/cm³, introduit un désordre cristallochimique qui, par déformation élastique à moyenne portée, entraîne une distribution de champ cristallin sur les sites de l'ion optiquement actif, comme l'Yb³⁺ par exemple. Ces variations aléatoires peuvent faire fluctuer l'énergie du niveau émetteur d'un site à l'autre sur un ordre de grandeur de quelques dizaines de cm⁻¹. Par conséquent, la bande d'émission sur laquelle est basée l'amplification optique dans le cristal est élargie. Du fait de la relation d'indétermination temps-énergie, cette largeur de bande d'émission ouvre la voie à la production d'impulsions ultracourtes ainsi qu'à une grande accordabilité du laser.

Selon une forme de réalisation particulière du procédé conforme à l'invention, les étapes 1) et 2) conduisant au mélange MP2 sont réalisées conjointement. Dans ce cas, la quantité molaire (z") du soluté au sein du mélange MP2 est alors telle que z"=z.z'% molaire, la quantité molaire du solvant primaire de formule (III) (t) est telle que t=z'(100-z)% molaire et la quantité molaire en additif est de s% molaire, avec s=(100-z')%.

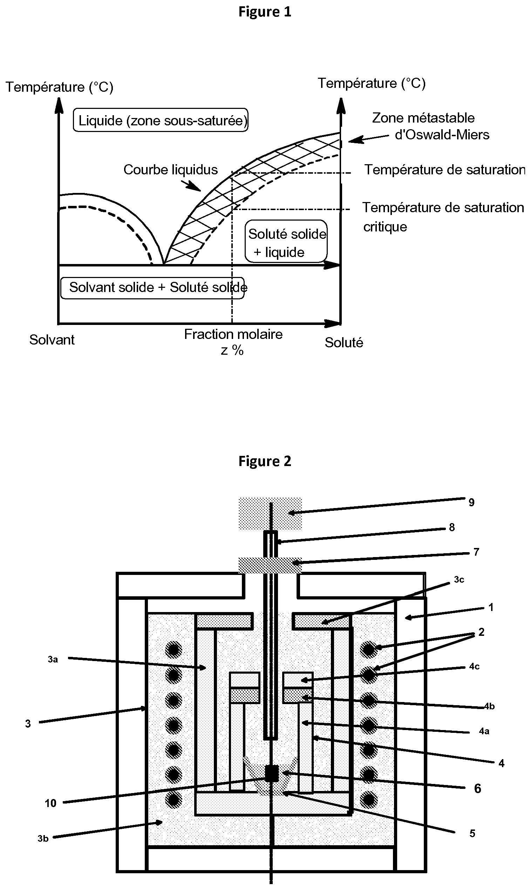

Au sens de la présente invention, les termes « représente le même élément que » utilisés pour qualifier les radicaux R'¹, R"¹, R'² et R"², en référence à R¹ et R² signifient par exemple que lorsque R¹ est l'yttrium (Y), R'¹= R"¹ = Y, et lorsque R² est l'ytterbium (Yb), R'² = R"² = Yb.On entend par température de saturation, la température pour laquelle la limite de solubilité du soluté dans la solution est atteinte (équilibre de solubilité). A cette température, et au-delà d'une certaine quantité de soluté déjà introduit et dissous en solution, le soluté additionnel peut précipiter sous forme solide. La température de saturation dépend de la quantité molaire « z" » du soluté dans la solution. L'équilibre de solubilité en fonction de la quantité molaire du soluté dans la solution est alors décrit par la courbe *liquidus* dans un diagramme de phase Solvant-Soluté ainsi que cela apparait sur la figure 1 annexée.

La température de sursaturation critique est la température pour laquelle la précipitation du soluté intervient spontanément. En dessous de cette limite, qui est également fonction de la quantité molaire « z" » du soluté dans la solution, la cristallisation du soluté ne peut pas être contrôlée et s'effectue de façon spontanée.

La température de sursaturation (T_{Sur}) est une température inférieure à la température de saturation et supérieure à la température de sursaturation critique. Elle correspond à une plage de températures dans laquelle le soluté se trouve dans un état métastable lui permettant de cristalliser de façon contrôlée sans qu'il y ait précipitation. La région thermodynamiquement métastable est comprise entre la température de saturation et la température de sursaturation critique ; elle est fonction de la quantité molaire « z" » du soluté dans la solution, et est dénommée « Région d'Oswald-Miers » (voir figure 1 annexée).

Selon l'invention, T_{Exp} correspond donc à la température « expérimentale » à laquelle on réalise la cristallisation contrôlée du sesquioxyde de formule (I) ; comme indiqué ci-dessus, cette température est comprise entre la température de saturation (T_{Sat}) de la solution liquide et la température de sursaturation critique (TC_{Sur}) de la solution liquide ou de la prise en masse de la solution ; pour un soluté donné, cette température est comprise dans la région d'Oswald-Miers.

Ces définitions se retrouvent dans l'ouvrage D. Elwell. H. J. Scheel. Crystal Growth from High-Temperature Solutions. Academic Press 1975, chapitre 4 (pp 138-201) et chapitre 7 (pp 278-432).

Toujours selon l'invention, on entend par « couche mince » une couche dont l'épaisseur varie de 1 à 500 µm et de préférence de 1 à 100 µm.

Dans la formule (I) ci-dessus, il est indiqué que R¹ représente au moins un métal de valence III. Cela signifie que R¹ peut être soit un élément unique choisi parmi le scandium, l'yttrium et les éléments de la série des lanthanides, soit une combinaison d'au moins 2 de ces éléments telle que par exemple une combinaison Y/Gd, Gd/La, Y/Lu, Gd/Lu, La/Lu, Y/La, Y/Sc, Gd/Sc, La/Sc ou Lu/Sc. Le cristal de formule (I) est dans ce cas ce qu'il est convenu d'appeler une solution solide dopée par au moins un ion de terre rare.

De la même manière, dans la formule (I) ci-dessus, il est indiqué que x est tel que 0 ≤ x < 1. Cela signifie que lorsque x = 0, R² est absent et que lorsque x > 0, R² est présent et est soit un élément unique choisi dans la série des lanthanides soit une combinaison d'au moins 2 de ces éléments telle que par exemple une combinaison Yb/Pr, Yb/Tm, Yb/Tb, Yb/Ho, Er/Yb, Tm/Tb, ou Tm/Ho, on parle alors de codopage ou de cristal codopé.

Selon une forme de réalisation préférée de l'invention, R¹ est choisi parmi les éléments Y, Gd, Tb, Eu, Sc et Lu et les combinaisons d'éléments Y/Gd, Y/Sc, Gd/Sc, Lu/Sc, Gd/La, Gd/Tb, Gd/Lu, Y/Lu, Eu/Gd, Eu/La et Eu/Lu.

Egalement selon une forme de réalisation préférée de l'invention, et lorsque x > 0, R² est choisi parmi les éléments Yb, Tm, Er, Pr, Tb, Nd, Ce, Ho, Eu, Sm et Dy et les combinaisons d'éléments Yb/Tm, Yb/Pr, Tm/Ho, Er/Yb, Yb/Tb, Yb/Ho, Eu/Sm et Tm/Tb.

Selon une forme de réalisation préférée de l'invention, ledit procédé est mis en oeuvre pour la préparation de sesquioxydes de formule (I) choisis parmi :
Tb₂O₃ ; Gd₂O₃ ; Eu₂O₃ ; Y₂O₃ ; Lu₂O₃ Sc₂O₃ ; (Tb,Gd)₂O₃ ; (Eu,Gd)₂O₃, Lu₂O₃:Yb ; Gd₂O₃:Yb ; Lu₂O₃:Eu ; Gd₂O₃:Eu ; Y₂O₃:Eu ; Y₂O₃:Er ; Gd₂O₃:Tm ; Gd₂O₃:Eu³⁺, (Y,Gd)₂O₃:Pr ; (Y,Gd)₂O₃:Eu ; (Y,Gd)₂O₃:Nd ; (Y,La)₂O₃:Pr ; (Gd,La)₂O₃:Pr ; (Gd,La)₂O₃:Yb ; (Gd,La)₂O₃:Eu ; (Gd,La)₂O₃:Nd ; (Y,La)₂O₃:Yb ; Y₂O₃:Er:Yb ; Y₂O₃:Pr:Yb ; Gd₂O₃:Er:Yb ; Gd₂O₃:Pr:Yb ; Gd₂O₃:Tm:Yb ; Lu₂O₃:Tm:Yb ; Y203:Tm:Ho ; Y203:Tm:Yb ; Y₂O₃:Tm:Tb ; Sc₂O₃:Eu ; (Y,Lu)₂O₃:Eu et (Gd,Lu)₂O₃:Eu.

Au sens de la présente invention, on appelle « soluté », un sesquioxyde de formule (IIa) ou le mélange d'un sesquioxyde de formule (IIa) et d'un sesquioxyde de formule (IIb), lesdites formules étant telles que définies précédemment.

Ainsi que cela a été défini précédemment le soluté est présent en une quantité molaire z" telle que 0 < z" < 93 % molaire du mélange MP2. Cette quantité correspond à la quantité maximale de soluté cristallisable sous forme monocristalline dans le solvant de synthèse de formule (IV) dans une gamme de températures inférieures à 1250°C.

Selon une forme de réalisation préférée de l'invention, la quantité z" de soluté présente au sein du mélange pulvérulent MP2 est > 0 % molaire et ≤ 30 % molaire, et encore plus préférentiellement cette quantité est telle que 5 ≤ z" ≤ 30 % molaire.

Selon une forme de réalisation préférée de l'invention, la quantité s de Li₂O et/ou de B₂O₃ et/ou de LiX présente au sein du mélange pulvérulent MP2 est > 0 % molaire et ≤ 30 % molaire, et encore plus préférentiellement cette quantité est telle que 5 ≤ s ≤ 30 % molaire.

Selon une forme également préférée de l'invention, Xₚₘ = 0 ou 0 < Xₚₘ ≤ 10 % molaire. Egalement selon une forme de réalisation préférée de l'invention, x a la même valeur que x' (x = x'), c'est-à-dire que le soluté et le solvant primaire contiennent la même quantité de dopant (R'²/R"²).

Selon une forme de réalisation particulière et préférée de l'invention, le mélange pulvérulent MP2 réalisé lors des étapes 1) et 2), et comprenant le soluté constitué d'un sesquioxyde de formule (IIa) en mélange ou non avec un sesquioxyde de formule (IIb) et le solvant de synthèse de formule (IV), est préparé selon un procédé comportant les sous-étapes consistant à :
i) préparer, par broyage mécanique, un mélange pulvérulent comprenant 6 moles de Li₂CO₃, 6 moles de H₃BO₃, 1+z moles d'un sesquioxyde de formule (IIa) ou d'un mélange d'un sesquioxyde de formule (IIa) et d'un sesquioxyde de formule (IIb), auquel on ajoute un excès de 20% molaire d'au moins un additif choisi parmi Li₂O (sous forme de Li₂CO₃), B₂O₃ (sous forme de H₃BO₃) et LiX avec X = F, Cl, Br ou I ;
ii) à soumettre le mélange obtenu ci-dessus à l'étape i) à un traitement thermique comprenant :
   - une montée en température jusqu'à une température T1 de 400 à 500°C environ, selon une rampe de montée en température de 120 à 180°C.h⁻¹ environ,
   - un palier de maintien de la température T1 pendant 6 à 24 heures environ,
   - une montée en température jusqu'à une température T2 de 700 à 800°C environ, selon une rampe de montée en température de 120 à 180°C.h⁻¹ environ,
   - un palier de maintien de la température T2 pendant 6 à 24 heures environ,
   - une remise à température ambiante avec une rampe de refroidissement de 120 à 180°C.h⁻¹ environ, pour obtenir un matériau solide sous forme de particules, ledit matériau étant constitué du solvant de synthèse de formule (IV) en mélange avec z" % molaire de soluté ;
iii) à broyer mécaniquement le matériau solide obtenu ci-dessus à l'étape ii) pour obtenir le mélange pulvérulent MP2.

Le broyage de l'étape iii) ci-dessus permet de réduire la granulométrie du matériau solide obtenu sous la forme de particules grossières à l'étape ii) ci-dessus et d'obtenir le mélange MP2 sous la forme d'un mélange intime du solvant de synthèse de formule (IV) et du soluté.

Lors de l'étape 3), la température T_{MP2} est de préférence de 1200°C à 1250°C et la vitesse à laquelle le mélange MP2 est porté à la température T_{MP2} est de préférence de l'ordre de 120°C.h⁻¹.

Lors de l'étape 5), la température TC_{Sur} est de préférence de l'ordre de 1100°C environ et le refroidissement contrôlé de la solution liquide depuis la température T_{MP2} jusqu'à une température T_{Exp} est de préférence réalisé à une vitesse de 0,1 à 1°C.h⁻¹.

Selon une forme de réalisation particulière du procédé, l'étape 5) de refroidissement contrôlé peut être réalisée en effectuant un tirage du cristal, c'est-à-dire en faisant remonter lentement le support solide, toujours sous rotation, selon un mouvement vertical. Ce tirage permet de privilégier une direction de croissance donnée selon une famille de plans bien déterminée dans le but de conduire à un monocristal répondant aux propriétés physiques recherchées pour celui-ci en fonction de l'application envisagée. Dans ce cas, le tirage peut être effectué à une vitesse de tirage (V_{T}) telle que 0,01 ≤ V_{T} ≤ 0,1 mm.h⁻¹.

Selon une forme de réalisation préférée de l'invention, l'étape 4) est réalisée sans tirage du cristal (V_{T} = 0 mm.h⁻¹).

Les sesquioxydes de formule (IIa) et (IIb) utilisé à l'étape 1) du procédé conforme à l'invention sont des produits commerciaux ou sont obtenus par réduction de produits commerciaux par traitement thermique.

Les différentes étapes du procédé conforme à l'invention, ainsi que les sous-étapes i) à iii) des étapes 1) et 2) le cas échéant, sont réalisées dans un creuset chimiquement inerte vis-à-vis des espèces qu'il contient. Un tel creuset peut par exemple être choisi parmi les creusets de platine, d'iridium ou de carbone vitreux.

Lorsqu'un creuset de platine (uniquement dans ce cas) est utilisé, les différentes étapes du procédé peuvent être réalisées à l'air (atmosphère ambiante) sauf lorsque R¹ désigne le cérium (Ce) et/ou le terbium (Tb) et/ou le praséodyme (Pr), alors les étapes du procédé sont de préférence réalisées sous atmosphère neutre ou réductrice, par exemple sous argon à 5 % en volume d'hydrogène. Lorsqu'un creuset d'iridium ou de carbone vitreux est utilisé, les étapes du procédé sont de préférence réalisées sous atmosphère neutre, par exemple sous argon, mais peuvent néanmoins être réalisées sous atmosphère réductrice bien que cela ne soit pas préféré sauf avec le cérium, le praséodyme et le terbium.

Le support solide de cristallisation est de préférence constitué d'une spatule en platine, d'un fil de platine, d'un ensemble formé d'un disque de platine fixé horizontalement en son centre à un fil de platine vertical lui même suspendu à une canne d'alumine ou bien encore d'un germe monocristallin orienté ou polycristallin fixé à un fil de platine lui-même suspendu à une canne d'alumine.

Selon une forme de réalisation préférée, le support solide de cristallisation est une spatule de platine en forme de pelle, de fil platine (diamètre de l'ordre du millimètre), de « T » inversé en platine (dans ce cas la barre horizontale du « T » est parallèle au fond du creuset), de "L" en platine ou d'un disque horizontal fixé en son centre par un fil platine ayant un diamètre de l'ordre du millimètre.

Lorsque la croissance du monocristal de formule (I) est réalisée en utilisant comme support solide, un germe monocristallin orienté ou polycristallin, celui-ci est alors de la même nature chimique et/ou structurale que le soluté que l'on veut faire cristalliser (par exemple un sesquioxyde de terre rare). Le germe est alors immergé dans la solution liquide afin que la croissance par épitaxie en phase liquide (LPE) du soluté puisse se réaliser sur ledit germe, ce qui est aussi le cas lors de l'utilisation des objets platine mentionnés ci-dessus. Lorsque la croissance est réalisée par LPE, le monocristal de formule (I) est obtenu sous la forme de couche mince.

Les différentes étapes du procédé nécessitant un traitement thermique sans agitation (étape 3), et sous-étapes ii) des étapes 1) et 2) sont de préférence réalisées dans un four tubulaire vertical ou dans un four à moufle.

Les différentes étapes du procédé nécessitant un traitement thermique sous agitation (étapes 4) et 5)), sont de préférence réalisées dans un four tubulaire vertical équipé d'une spatule d'homogénéisation de la solution liquide et pouvant servir de support de cristallisation, ladite spatule étant solidaire d'un système mécanique de rotation/translation/pesée *via* le support solide de cristallisation (germe ou fil de platine ou spatule platine, etc...) fixé à une canne en alumine elle-même reliée au système de rotation/tirage/pesée.

L'étape 6) du procédé est de préférence réalisée dans un four tubulaire vertical sans agitation.

Lors des étapes 4) et 5), la vitesse de rotation du support solide varie de préférence de 5 à 50 tours/min, et encore plus particulièrement de 10 à 35 tours/min lors de l'étape 5).

Selon une forme de réalisation préférée du procédé de l'invention, le refroidissement de l'étape 5) est effectué à une vitesse de 0,2°C.h⁻¹ depuis la température T_{MP2} jusqu'à une température TC_{Sur} de 1100°C, après extraction du support en dehors du liquide et positionnement de celui-ci au dessus de la solution liquide, puis la température de 1100°C est maintenue pendant une durée de moins de 1 heure (thermalisation) avant de procéder au refroidissement mentionné à l'étape 6). Dans ce cas, le refroidissement de l'étape 6) est de préférence réalisé à une vitesse inférieure à 50°C.h⁻¹ environ et peut être réalisé en plusieurs étapes.

Selon une autre forme de réalisation préférée du procédé de l'invention, le refroidissement de l'étape 5) est un refroidissement en « dents de scie », c'est-à-dire un traitement thermique comportant une alternance d'étapes de refroidissement et d'étapes de remontée en température dans lequel l'amplitude de chaque étape de remontée en température est inférieure ou égale à l'amplitude de l'étape de refroidissement qui la précède. Selon une forme de réalisation particulière de réalisation, la vitesse de refroidissement varie de préférence de 0,1 à 0,2°C.h⁻¹ et le refroidissement de l'étape 5) est effectué selon le traitement thermique suivant :
Température de départ : 1200°C
   i) rampe de 0,2°C.h⁻¹ jusqu'à 1175°C,
   ii) rampe de 180°C.h⁻¹ jusqu'à 1190°C,
   iii) rampe de 0,2°C.h⁻¹ jusqu'à 1150°C,
   iv) rampe de 180°C.h⁻¹ jusqu'à 1165°C,
   v) rampe de 0,2°C.h⁻¹ jusqu'à 1125°C,
   vi) rampe de 180°C.h⁻¹ jusqu'à 1140°C,
   vii) rampe de 0,2°C.h⁻¹ jusqu'à 1100°C,
   viii) rampe de 180°C.h⁻¹ jusqu'à 1115°C,
   ix) rampe de 0,2°C.h⁻¹ jusqu'à 1100°C.

Selon cette forme de réalisation, le refroidissement de l'étape 6) est alors de préférence réalisé à une vitesse de 5°C.h⁻¹ jusqu'à 800°C puis de 30°C.h⁻¹ environ jusqu'à la température ambiante et encore plus préférentiellement de 0,5°C.h⁻¹ jusqu'à 1000°C, puis de 5°C.h⁻¹ jusqu'à 800°C et de 30°C.h⁻¹ jusqu'à la température ambiante.

La réalisation de l'étape 5) selon un tel traitement thermique en « dents de scie » présente l'avantage de limiter la nucléation hétérogène multiple sur le support solide (germe, spatule platine, disque platine ou fil platine, etc...) et facilite donc l'obtention d'un seul monocristal de bonne qualité.

Du fait de leurs très bonnes qualités cristallines et de leur taille importante, les sesquioxydes monocristallins de formule (I) obtenus selon le procédé conforme à la présente invention peuvent avantageusement être utilisés dans le domaine de l'optique ou comme substrat pour l'épitaxie en phase solide, liquide ou gazeuse.

Les sesquioxydes monocristallins de formule (I) telle que définie précédemment et obtenus selon le procédé conforme à la présente invention, peuvent être utilisés pour des applications optiques, pour la fabrication de matériaux pour le refroidissement optique, comme isolateur optique et comme substrats orienté (en particulier selon la direction 2-1-1) pour l'épitaxie.

En particulier, les sesquioxydes de formule (I) dans lesquels x = 0 (composés non dopés) peuvent être utilisés comme isolateur optique et comme cristal rotateur pour la circulation optique par rotation de Faraday, ce qui constitue un autre objet de l'invention.

La présente invention est illustrée par les exemples de réalisation suivants, auxquels elle n'est cependant pas limitée.

### EXEMPLES

Les matières premières utilisées dans ces exemples sont des poudres de pureté 99,99% %.
- Poudres de Gd₂O₃, de Yb₂O₃, de Li₂CO₃ et de H₃BO₃ vendues par la société Fox Chemicals,
- Poudre de Tb₄O₇ vendue par la société Oxymet Ltd.

Exceptée la poudre commerciale de Tb₄O₇, les autres poudres ont été utilisées telles que reçues du fabricant.

Les réactions de synthèse des poudres de soluté et de solvant de synthèse de formule (IV) peuvent être réalisées simultanément dans le même creuset platine après mélange intime et broyage préalable de celles-ci entre elles.

### EXEMPLE 1

### Cristallogenèse de monocristaux de Gd₂O₃ dopés à l'ytterbium selon le procédé conforme à l'invention

Dans cet exemple, on a préparé des sesquioxydes cubiques monocristallins de gadolinium dopés à xₚₘ=6,67 % molaire (x=x'=0,0667) par de l'ytterbium : Gd₂O₃ : Yb³⁺, en utilisant [Li₆(Gd_{0,9333}Yb_{0,0667})(BO₃)₃] comme solvant primaire auquel on a ajouté z=20% molaire de soluté Gd₂O₃:Yb³⁺.

Un excès de s=19,35 mol.% de Li₂O a ensuite été ajouté à ce mélange de base.

### 1) Première étape : Préparation d'un mélange MP2 constitué de [Li₆(Gd_{0,9333}Yb_{0,0667})(BO₃)₃], de Li₂O et de (Gd_{0,9333}Yb_{0,0667})₂O₃ :

### 1.1) Préparation d'un soluté constitué d'un mélange mécanique de sesquioxyde de gadolinium et de sesquioxyde d'ytterbium :

La préparation du soluté a été réalisée en mélangeant de façon mécanique 93,33 % molaire de Gd₂O₃ et 6,67 % molaire de Yb₂O₃.

Les poudres commerciales de Gd₂O₃ et d'Yb₂O₃ ont été mélangées selon les proportions stoechiométriques indiquées ci-dessus, puis broyées intimement dans un mortier afin d'obtenir une granulométrie la plus fine et un mélange mécanique le plus homogène possibles. On a ainsi obtenu 32,4 g d'un soluté Gd₂O₃ dopé à l'ytterbium de formulation (Gd_{0,9333}Yb_{0,0667})₂O₃.

### 1.2) Préparation d'un mélange MP1 constitué de (Gd_{0,333}Yb_{0,0667})₂O₃ à titre de soluté et de [Li₆(Gd_{0,9333}Yb_{0,0667})(BO₃)₃ à titre de solvant primaire.

La synthèse du mélange MP1 a été effectuée selon la réaction 1 suivante :

6 Li₂CO₃ + 6 H₃BO₃ + 0,9333 Gd₂O₃ + 0,0667 Yb₂O₃ + 0,20 (Gd_{0,9333}Yb_{0,0667})₂O₃ → 2 [Li₆(Gd_{0,9333}Yb_{0,0667})(BO₃)₃] + 0,20 (Gd_{0,9333}Yb_{0,0667})₂O₃ + 9 H₂O + 6 CO₂ (Réaction 1)

Les poudres commerciales de Li₂CO₃, H₃BO₃, Gd₂O₃ et Yb₂O₃ ont été au préalable mélangées selon les proportions stoechiométriques indiquées par la réaction 1 ci-dessus, puis broyées intimement dans un mortier afin d'obtenir une granulométrie la plus fine et un mélange mécanique le plus homogène possibles.

133,3055 g de solvant primaire et 32,4g de soluté (Gd_{0,9333}Yb_{0,0667})₂O₃ ont été préparés, soit z=20% molaire de soluté au sein du solvant primaire. 165,7055 g de mélange MP1 ont ainsi été obtenus.

### 1.3) Préparation d'un mélange MP2

7,8542 g de Li₂CO₃ (soit l'équivalent de 3,1763g de Li₂O) ont été rajoutés au mélange MP1 obtenu ci-dessus à l'étape 1.2). Ceci correspond à un ajout de s=19,35% molaire d'excès de Li₂O par rapport au mélange MP1.

Les poudres commerciales de Li₂CO₃ et du mélange MP1 ont été mélangées puis broyées intimement dans un mortier afin d'obtenir une granulométrie la plus fine et un mélange mécanique le plus homogène possibles.

Le mélange résultant a ensuite été chauffé dans un creuset en platine sous une atmosphère d'air selon le traitement thermique suivant :
1) rampe de 120°C.h⁻¹ jusqu'à 500°C puis palier de 12 h ;
2) rampe de 120°C.h⁻¹ jusqu'à 800°C puis palier de 12 h ;
3) rampe de 180°C.h⁻¹ jusqu'à 1250°C puis palier de 2h, ceci pour entrainer la dissolution du soluté dans le solvant de synthèse.
4) refroidissement jusqu'à température ambiante avec une vitesse de refroidissement de 180°C.h⁻¹.

Le mélange MP2 ainsi obtenu, composé du solvant de synthèse [Li₆(Gd_{0,9333}Yb_{0,0667})(BO₃)₃] + Li₂O auquel a été ajouté le soluté, a ensuite été broyé à l'aide d'un mortier et d'un pilon en Agathe. On a ainsi obtenu un mélange MP2 constitué de 136,4818 g de solvant de synthèse et de 32,4g de soluté, soit z"=16,14% molaire de soluté au sein du solvant de synthèse.

### 2) Deuxième étape : Cristallogenèse des monocristaux de Gd₂O₃:Yb³⁺

La mise en fusion du mélange MP2 obtenu ci-dessus à l'étape 2) a ensuite été effectuée sous air, dans un four tubulaire vertical, en appliquant tout d'abord une rampe de montée en température de 180°C.h⁻¹ jusqu'à 1250°C.

Le four tubulaire vertical utilisé dans cet exemple, est représenté sur la figure 2 annexée. Il comprend une enceinte en acier inoxydable (1) refroidie par eau, dans laquelle sont disposés des éléments chauffants (2) et une enceinte interne (3) en matériau réfractaire constituée d'un tube en alumine (3a), de laine de silice et de Fibrothal® (3b) et d'une rondelle d'alumine (3c). L'enceinte interne (3) renferme un réflecteur thermique (4) disposé autour d'un creuset (5) contenant le mélange réactionnel (solution) (6) en fusion, ledit réflecteur thermique (4) étant constitué d'un tube d'alumine (4a) support du réflecteur (4) surmonté d'une rondelle de platine (4b) elle-même surmontée d'une rondelle d'alumine (4c). Sur sa partie supérieure, l'enceinte (1) est munie d'un passage étanche (7) garantissant l'atmosphère de croissance dans l'enceinte du four, par lequel passe une canne (8) en alumine solidaire d'un système mécanique de rotation/translation et d'un dispositif de pesée (balance ayant une précision de 10⁻³ g) (9) et comportant à son extrémité un support solide d'homogénéisation et de contre-sédimentation du soluté (10) par agitation du soluté dans le solvant pour la croissance du monocristal, ledit support (10) étant immergé dans le mélange réactionnel (6) contenu dans le creuset (5).

Le support (10) peut être constitué d'une spatule en platine, d'un fil de platine, d'un ensemble formé d'un disque de platine fixé horizontalement en son centre à un fil de platine vertical lui même suspendu à une canne d'alumine ou bien encore d'un germe cristallin orienté ou polycristallin fixé à un fil de platine lui-même suspendu à une canne d'alumine.

Dans cet exemple, le support solide (10) qui a été utilisé était un disque de platine fixé horizontalement en son centre à un fil de platine vertical lui même suspendu à une canne d'alumine.

Les gradients thermiques dans le four (gradients radial et longitudinal) sont de l'ordre de 1°C.cm⁻¹ de sorte que la température minimale du mélange réactionnel se situe au centre et à la surface du mélange réactionnel.

Le réflecteur thermique (4), muni d'une rondelle d'alumine (épaisseur > 1 mm) (4b) doublée d'une rondelle de graphite (épaisseur > 2 mm) (4c), permet de diminuer les gradients thermiques. La température au sein du mélange réactionnel est ainsi homogénéisée.

Après thermalisation, le support solide a été immergé par translation suivant l'axe du four (1) et du creuset (5) dans le mélange réactionnel jusqu'à une hauteur de 1 mm à partir du fond du creuset de façon à ce que seul le platine constituant le disque et le fil du support (10) soit en contact avec le mélange réactionnel fondu et que l'extrémité de la canne (8) en alumine (point d'attache entre le fil en platine et la canne) soit au moins à plus de 1 cm de la surface du mélange réactionnel au minimum.

Le disque platine a été immergé par translation dans le mélange réactionnel au centre du creuset Une agitation par rotation autour de l'axe de la canne, de l'ordre de 30 tours/mn a été effectuée pendant 24 heures à 1250°C dans le but de bien homogénéiser les espèces dissoutes (soluté) dans le solvant de synthèse et d'éviter leur sédimentation le cas échéant.

Compte tenu de la viscosité importante du bain fondu, une agitation suffisante, de l'ordre de 20 tr/mn ou plus, s'est avérée nécessaire pour maintenir dissoutes les espèces dans toute la phase liquide et atténuer les effets de sédimentation du soluté.

La croissance cristalline a été effectuée selon le programme de traitement thermique suivant :
Température de départ : 20 °C
   - rampe de 120°C.h⁻¹ jusqu'à 1250°C, puis palier de 24 h,
   - rampe de 180°C.h⁻¹ jusqu'à 1200°C, puis palier de 4 h,
   - rampe de 0,2°C.h⁻¹ jusqu'à 1175°C puis palier de 0,1 h,
   - rampe de 180°C.h⁻¹ jusqu'à 1190°C puis palier de 0,1 h,
   - rampe de 0,2°C.h⁻¹ jusqu'à 1150°C puis palier de 0,1 h,
   - rampe de 180°C.h⁻¹ jusqu'à 1165°C, puis palier de 0,1 h,
   - rampe de 0,2°C.h⁻¹ jusqu'à 1125°C puis palier de 0,1 h,
   - rampe de 180°C.h⁻¹ jusqu'à 1140°C puis palier de 0,1 h,
   - rampe de 0,2°C.h⁻¹ jusqu'à 1100°C puis palier de 0,1 h,
   - rampe de 180°C.h⁻¹ jusqu'à 1115°C puis palier de 0,1 h,
   - rampe de 0,2°C.h⁻¹ jusqu'à 1100°C puis palier de 0,1 h,
   - pas de tirage depuis la solution,
   - extraction du disque de platine au-dessus du bain fondu à 1100°C,
   - rampe de 0,5°C.h⁻¹ jusqu'à 1000°C,
   - rampe de 2°C.h⁻¹ jusqu'à 800°C,
   - rampe de 60°C.h⁻¹ jusqu'à la température ambiante.

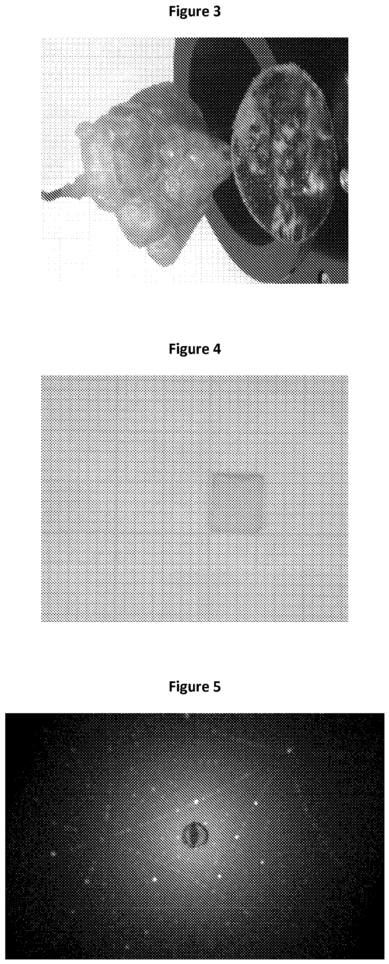

Une photographie des cristaux de Gd₂O₃:Yb³⁺ ainsi obtenus est donnée sur la figure 3 annexée. Sur cette figure, les cristaux de Gd₂O₃:Yb³⁺ ont été placés sur une feuille de papier millimétré. On constate que les cristaux présentent une taille de l'ordre du centimètre dans leur grande longueur. Une photo d'un cristal poli de plus de 25 mm² de surface et 1,5 mm d'épaisseur ne présentant aucune inclusion est présentée sur la figure 4 annexée. Le volume utile d'un tel cristal est par conséquent très important.

Le diagramme de diffraction de Laue est représenté sur la figure 5 annexée. Sur cette figure, Les mesures ont été effectuées sur une face naturelle d'un monocristal de Gd₂O₃:Yb³⁺ orientée (-2-1-1) sur un goniomètre vendu sous la référence GM WS Series X-Ray par la société Delta Technologies International, en utilisant une anti cathode au molybdène et une caméra CCD de la marque Photonics Science. Ce diagramme est conforme à la structure théorique attendue et confirme la structure cubique du monocristal de Gd₂O₃:Yb³⁺ obtenu dans cet exemple.

### EXEMPLE 1 COMPARATIF

### Cristallogenèse de monocristaux de Gd₂O₃ dopés à l'ytterbium selon un procédé NON conforme à l'invention

A titre d'exemple comparatif à l'exemple 1 ci-dessus, des monocristaux de Gd₂O₃ dopés à 6,67% (molaire) par de l'ytterbium ont été préparés selon un procédé non conforme à l'invention, c'est-à-dire en utilisant [Li₆(Gd_{0,9333}Yb_{0,0667})(BO₃)₃] comme solvant (mélange ne contenant pas de Li₂O) auquel on a ajouté 20% molaire de soluté Gd₂O₃:Yb³⁺ de formulation (Gd_{0,9333}Yb_{0,0667})₂O₃ selon le procédé décrit dans la demande internationale WO 2012/055075.

### 1) Première étape : Préparation d'un soluté constitué d'un mélange mécanique de sesquioxyde de gadolinium et de sesquioxyde d'ytterbium :

La préparation du soluté été réalisée en mélangeant de façon mécanique 93,33 % molaire de Gd₂O₃ et 6,67 % molaire de Yb₂O₃ selon le même procédé que celui de l'étape 1) de l'exemple 1 ci-dessus.

### 2) Deuxième étape : Préparation du mélange pour la synthèse

La préparation du mélange pour la synthèse a été effectuée selon la réaction 1 suivante :

6 Li₂CO₃ + 6 H₃BO₃ + 0,9333 Gd₂O₃ + 0,0667 Yb₂O₃ → 2 [Li₆(Gd_{0,9333}Yb_{0,0667})(BO₃)₃] + 0,20 (Gd_{0,9333}Yb_{0,0667})₂O₃ + 9 H₂O + 6 CO₂ (Réaction 1)

Les poudres commerciales de Li₂CO₃, H₃BO₃, Gd₂O₃ et Yb₂O₃ ont été mélangées selon les proportions stoechiométriques indiquées par la réaction 1 ci-dessus, puis broyées intimement dans un mortier afin d'obtenir une granulométrie la plus fine et un mélange mécanique le plus homogène possibles. Le mélange a ensuite été chauffé dans un creuset en platine sous une atmosphère d'air selon le traitement thermique suivant :
1) rampe de 120°C.h⁻¹ jusqu'à 500°C puis palier de 12 h ;
2) rampe de 120°C.h⁻¹ jusqu'à 800°C puis palier de 12 h ;
3) rampe de 180°C.h⁻¹ jusqu'à 1250°C puis palier de 2 h ;
4) refroidissement jusqu'à température ambiante avec une vitesse de refroidissement de 180°C.h⁻¹.

Le mélange de [Li₆(Gd_{0,9333}Yb_{0,0667})(BO₃)₃] et de (Gd_{0,9333}Yb_{0,0667})₂O₃ ainsi obtenu a ensuite été broyé à l'aide d'un mortier et d'un pilon en Agathe.

### 3) Troisième étape : Cristallogenèse des monocristaux de Gd₂O₃:Yb³⁺

133,3055 g (80% molaire) du solvant [Li₆(Gd_{0,9333}Yb_{0,0667})(BO₃)₃] obtenu ci-dessus à l'étape 2) et 32,400 g (20 % molaire) du soluté préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La mise en fusion de la solution composée de [Li₆(Gd_{0,9333}Yb_{0,0667})(BO₃)₃] (solvant primaire) et du soluté de formulation (Gd_{0,9333}Yb_{0,0667})₂O₃ a ensuite été effectuée sous air, dans le même four tubulaire vertical que celui utilisé ci-dessus dans l'exemple 1, en appliquant tout d'abord une rampe de montée en température de 180°C.h⁻¹ jusqu'à 1200°C.

La cristallisation de Gd₂O₃:Yb³⁺ a été réalisée dans le four décrit ci-dessus à l'exemple 1, selon le protocole décrit à l'exemple 1, en utilisant le même support que ci-dessus à l'exemple 1, une atmosphère d'air et selon le même programme de traitement thermique que celui-ci mis en oeuvre ci-dessus à l'exemple 1.

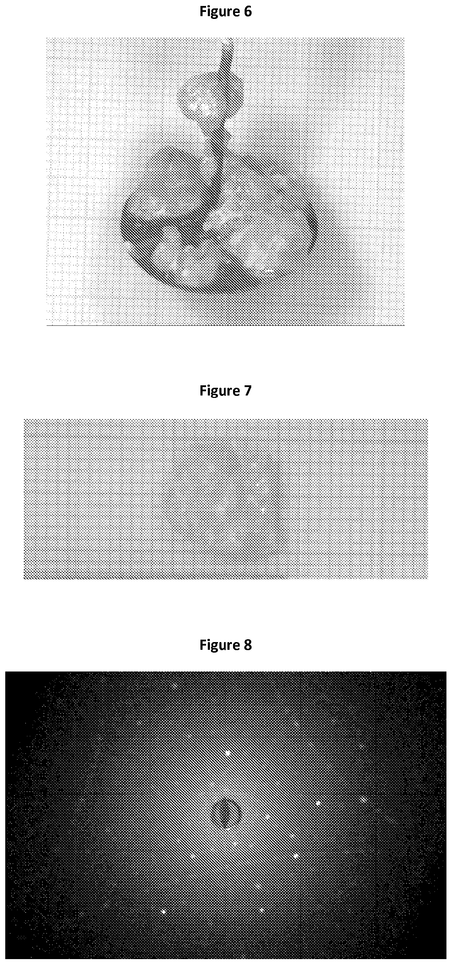

On a obtenu des monocristaux de Gd₂O₃:Yb³⁺ sur la spatule platine avec un disque horizontale dont une photographie est donnée par la figure 6 annexée. Sur cette figure, les cristaux de Gd₂O₃:Yb³⁺ ont été placés sur une feuille de papier millimétré. On constate que les cristaux obtenus sont plus nombreux et présentent une taille moyenne inférieure à celle des cristaux obtenus à l'exemple 1 ci-dessus (dans leur grande longueur). Une photo d'un cristal centimétrique est représentée sur la figure 7 annexée. Sur cette figure on constate que le cristal obtenu selon le procédé non conforme à l'invention, c'est-à-dire en utilisant un solvant de synthèse ne contenant pas de Li₂O, comprend de nombreuses inclusions qui ont pour conséquence de venir limiter le volume utile du cristal, c'est-à-dire le volume où il n'y a pas d'inclusion.

Le diagramme de diffraction de Laue est représenté sur la figure 8 annexée. Les mesures ont été effectuées sur une face naturelle d'un monocristal de Gd₂O₃ orientée (-2-1-1) sur un goniomètre vendu sous la référence GM WS Series X-Ray par la société Delta Technologies International, en utilisant une anti cathode au molybdène et une caméra CCD de la marque Photonics Science. Ce diagramme est conforme à la structure théorique attendue et confirme la structure cubique du monocristal de Gd₂O₃ pur obtenu.

### EXEMPLE 2

### Cristallogenèse de monocristaux de Tb₂O₃ selon le procédé conforme à l'invention

Dans cet exemple, on a préparé des sesquioxydes cubiques monocristallins de terbium pur (Xₚₘ=0 et x=0) : Tb₂O₃, en utilisant [Li₆Tb(BO₃)₃] comme solvant primaire auquel on a ajouté z=17% molaire de soluté Tb₂O₃.

Un excès de s=20% molaire de Li₂O a ensuite été ajouté à ce mélange de base.

### 1) Première étape : Préparation du soluté Tb₂O₃

Avant son utilisation, la poudre commerciale de Tb₂O₃ a été préalablement chauffée sous Argon-H₂ (5%) séparément afin d'obtenir une poudre de Tb₂O₃ parfaitement stoechiométrique déshydratée ne présentant que des atomes de terbium de valence (+III), selon la réaction (2) suivante :

Tb₄O₇ → 2Tb₂O₃ + 0,5 O₂ (Réaction 2)

Le traitement thermique a été le suivant :
1) rampe de 180°C.h⁻¹ jusqu'à 500°C puis palier de 3 h ;
2) rampe de 180°C.h⁻¹ jusqu'à 850°C puis palier de 3 h ;
3) rampe de 180°C.h⁻¹ jusqu'à 1250°C puis palier de 48 h ;
4) refroidissement jusqu'à température ambiante avec une vitesse de refroidissement de 120°C.h⁻¹.

Ce traitement thermique a été réalisé dans un creuset en platine.

La poudre de Tb₂O₃ a alors ensuite été engagée dans la synthèse cristalline dans l'heure qui a suivi la fin du traitement thermique mentionné ci-dessus afin d'éviter toute reprise d'humidité.

### 2) Deuxième étape : Préparation d'un mélange MP1 constitué de Tb₂O₃ et de [Li₆Tb(BO₃)₃] à titre de solvant primaire

La préparation du mélange MP1 a été effectuée selon la réaction 3 suivante :

6 Li₂CO₃ + 6 H₃BO₃ + 1,17 Tb₂O₃ → 2 [Li₆Tb(BO₃)₃] + 0,17 Tb₂O₃ + 9 H₂O + 6 CO₂ (Réaction 3)

Les poudres commerciales de Li₂CO₃, H₃BO₃, et celle de Tb₂O₃ telle que préparée ci-dessus à l'étape 1), ont été mélangées selon les proportions stoechiométriques indiquées par la réaction 3 ci-dessus, puis broyées intimement dans un mortier afin d'obtenir une granulométrie la plus fine et un mélange mécanique le plus homogène possibles.

98,2793 g de solvant primaire et 19,5344g de soluté Tb₂O₃ ont été préparés. 117,8137g de mélangé MP1 sont ainsi obtenus.

### 3) Troisième étape : Préparation d'un mélange MP2 par ajout de Li₂O en excès molaire au mélange MP1 décrit ci-dessus dans l'étape 2)

5,8018 g de Li₂CO₃ (soit l'équivalent de 2,3463g de Li₂O) ont été rajoutés aux 117,8137 g de mélange MP1 obtenu ci-dessus à l'étape précédente. Ceci correspond à un ajout de 20% molaire d'excès de Li₂O par rapport au mélange MP1.

Les poudres commerciales de Li₂CO₃ et du mélange MP1 ont été mélangées puis broyées intimement dans un mortier afin d'obtenir une granulométrie la plus fine et un mélange mécanique le plus homogène possibles.

Le mélange résultant a ensuite été chauffé dans un creuset en platine sous une atmosphère d'argon/H₂ (5%volumique) selon le traitement thermique suivant :
1) rampe de 120°C.h⁻¹ jusqu'à 500°C puis palier de 12 h ;
2) rampe de 120°C.h⁻¹ jusqu'à 800°C puis palier de 12 h ;
3) rampe de 180°C.h⁻¹ jusqu'à 1250°C puis palier de 2 h ;
4) refroidissement jusqu'à température ambiante avec une vitesse de refroidissement de 180°C.h⁻¹.

Le mélange MP2 a ensuite été broyé à l'aide d'un mortier et d'un pilon en Agathe. On a ainsi obtenu 120,16 g de mélange MP2 constitué de 100,6256 g de solvant de synthèse et de 19,5344g de Tb₂O₃ soit z" = 13,6% molaire de soluté dans le solvant de synthèse.

### 4) Quatrième étape : Cristallogenèse des monocristaux de Tb₂O₃

Le mélange MP2 obtenu ci-dessus à l'étape précédente a ensuite été placé dans un creuset de platine.

La mise en fusion du mélange MP2 a ensuite été effectuée sous argon, dans un four tubulaire vertical identique à celui utilisé ci-dessus à l'exemple 1, en appliquant tout d'abord une rampe de montée en température de 180°C.h⁻¹ jusqu'à 1235°C.

Une spatule en forme de pelle a été immergée par translation dans le mélange réactionnel au centre du creuset. Une agitation par rotation autour de l'axe de la canne, de l'ordre de 30 tours/mn a été effectuée pendant 24 heures à 1235°C dans le but de bien homogénéiser les espèces dissoutes (soluté) dans le solvant de synthèse et d'éviter leur sédimentation le cas échéant.

Compte tenu de la viscosité importante du bain fondu, une agitation suffisante, de l'ordre de 20 tr/mn, s'est avérée nécessaire pour maintenir dissoutes les espèces dans toute la phase liquide et atténuer les effets de sédimentation du soluté. La croissance cristalline a été effectuée selon le programme de traitement thermique suivant :
Température de départ : 20 °C,
   - rampe de 180°C.h⁻¹ jusqu'à 1235°C, puis palier de 24 h,
   - refroidissement à une vitesse de 0,2°C.h⁻¹ jusqu'à 1175°C,
   - remontée à une vitesse de 120°C jusqu'à 1210°C,
   - refroidissement à une vitesse de 0,2°C.h⁻¹ jusqu'à 1160°C,
   - pas de tirage depuis la solution sur la plage de température de 1235°C à 1160°C,
   - extraction de la spatule au-dessus du bain fondu à 1160°C,
   - rampe de 7°C.h⁻¹ jusqu'à 800°C,
   - rampe de 30°C.h⁻¹ jusqu'à la température ambiante.

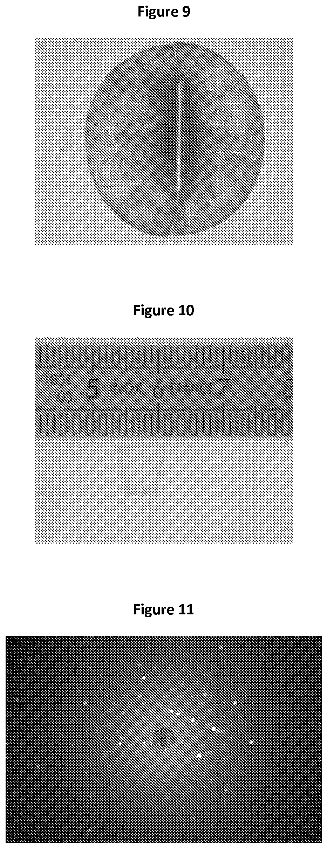

Un large disque composé de plusieurs monocristaux de Tb₂O₃ a ainsi été obtenu au bout d'environ 20 jours. La photographie de celui-ci est donnée par la figure 9 annexée. Sur cette figure, le disque de Tb₂O₃ a été placé sur du papier millimétré (1 carreau = 1 mm). On constate que les cristaux présentent une taille de l'ordre du centimètre. La figure 10 annexée présente une photographie d'une partie extraite du disque, cette partie présentant des dimensions de plus de 5x5x1.2 mm³ sans aucune inclusion.

Par ailleurs, le diagramme de diffraction de Laue obtenu par la méthode de Laue est représenté sur la figure 11 annexée. L'axe de croissance du disque a été déterminé comme étant (621). Les mesures ont été effectuées sur un goniomètre vendu sous la référence GM WS Series X-Ray par la société Delta Technologies International, en utilisant une anti cathode au molybdène et une caméra CCD de la marque Photonics Science. Ce diagramme est conforme à la structure théorique attendue et confirme la structure cubique d'un des monocristaux de Tb₂O₃ obtenu.

Ce cristal a aussi été testé afin de mesurer sa constante de Verdet. Pour rappel, un milieu diamagnétique ou paramagnétique isotrope non absorbant, ou plus généralement ne présentant pas de différence d'absorption entre deux modes de polarisations circulaires droite et gauche de la lumière, provoque une simple rotation θ de la polarisation du champ électrique d'une onde électromagnétique polarisée rectilignement lorsque ce milieu est soumis à un champ magnétique d'induction B appliqué le long de la direction de propagation de cette onde. Ce phénomène, appelé effet Faraday, résulte de la biréfringence circulaire magnétique induite dans le milieu, dont l'effet simple passage (uniquement) est similaire à la celui de la biréfringence circulaire naturelle encore appelée activité optique. La théorie classique de l'électron (modèle de Lorentz) associée aux équations de Maxwell permet de montrer que la rotation Faraday est à la fois proportionnelle à l'amplitude du champ magnétique d'induction B et à la longueur 1 du matériau traversé, de sorte que l'on a : θ = V(λ).1. B, où V(λ) est une constante dépendant du matériau et fonction de la longueur d'onde λ : c'est la constante de Verdet.

Le cristal a été disposé au centre de l'entrefer d'un électro-aimant délivrant un champ magnétique continu pouvant aller de 0 mT à 1200 mT. De part et d'autre de l'ensemble, on a disposé un analyseur et un polariseur de façon croisée afin d'avoir l'extinction de la lumière au niveau du détecteur en aval. Puis on a fait passer une source laser en amont dont le vecteur d'onde est colinéaire au champ magnétique. A chaque valeur B du champ magnétique, on a fait tourner l'analyseur d'un angle θ (rad) afin d'obtenir de nouveau l'extinction de la lumière au niveau du détecteur.

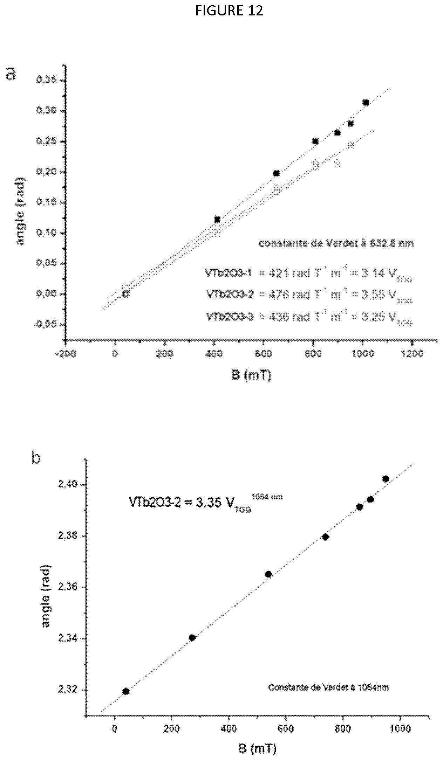

Les résultats obtenus sont représentés sur la figure 12 annexée. Les deux graphiques montrent les mesures effectuées pour 2 sources laser différentes (He-Ne à 632,8 nm (Figure 12a) et Nd :YAG à 1064 nm (Figure 12b)). Sur ces figures, l'angle (en rad) est fonction du champ magnétique B (en mT). La régression linéaire des droites obtenues donne la constante de Verdet V(λ).

Trois échantillons Tb₂O₃₋₁, Tb₂O₃₋₂ et Tb₂O₃₋₃ préparés selon le procédé décrit dans le présent exemple ont ainsi été testés à 632,8 nm et un échantillon (Tb₂O₃₋₂) a été testé à 1064 nm.

Les valeurs de V(λ) pour Tb₂O₃ ont été comparées à celles du TGG qui est le matériau le plus performant à l'heure actuelle en termes de valeurs de constante de Verdet. (V_{TGG}(632,8nm) = 134 rad.T⁻¹.m⁻¹; V_{TGG}(1064 nm) 40 rad.T⁻¹.m⁻¹).

Les résultats obtenus montrent que les valeurs de constante de Verdet pour Tb₂O₃ suivant ces 2 longueurs d'onde sont au minimum 3 fois supérieures à celle du TGG.

### EXEMPLE 2 COMPARATIF

### Cristallogenèse de monocristaux de Tb₂O₃ pur selon un procédé NON conforme à l'invention

Dans cet exemple, on a préparé des sesquioxydes cubiques monocristallins de terbium pur Tb₂O₃, selon un procédé non conforme à l'invention, c'est-à-dire en utilisant [Li₆Tb(BO₃)₃] comme solvant pour la synthèse (solvant ne contenant pas de Li₂O) avec 17% molaire de soluté Tb₂O₃.

### 1) Première étape : Préparation du soluté Tb₂O₃

Le soluté Tb₂O₃ a été préparé comme indiqué ci-dessus à l'étape 1) de l'exemple 2.

La poudre de Tb₂O₃ a alors ensuite été engagée dans la synthèse cristalline dans l'heure qui a suivi la fin du traitement thermique mentionné ci-dessus afin d'éviter toute reprise d'humidité.

### 2) Deuxième étape : Préparation du solvant [Li₆Tb(BO₃)₃] pour la synthèse

La préparation du solvant [Li₆Tb(BO₃)₃] pour la synthèse a été effectuée selon la réaction 3 décrite ci-dessus à l'étape 2) de l'exemple 2, suivant le même protocole.

On a ainsi obtenu 83,8504g du solvant [Li₆Tb(BO₃)₃] pour la synthèse qui a ensuite été broyé à l'aide d'un mortier et d'un pilon en Agate.

### 3) Troisième étape : Cristallogenèse des monocristaux de Tb₂O₃

83,8504 g (83% molaire) de [Li₆Tb(BO₃)] obtenu ci-dessus à l'étape 2) et 16,6662 g (17% % molaire) de Tb₂O₃ préparé ci-dessus à l'étape 1) ont été mélangés et broyés intimement ensemble dans un mortier afin d'obtenir une granulométrie la plus fine et un mélange mécanique le plus homogène possibles. Ce mélange a ensuite été placé dans un creuset de platine.

La croissance cristalline a ensuite été réalisée dans les mêmes conditions que celles détaillées ci-dessus à l'étape 4) de l'exemple 2.

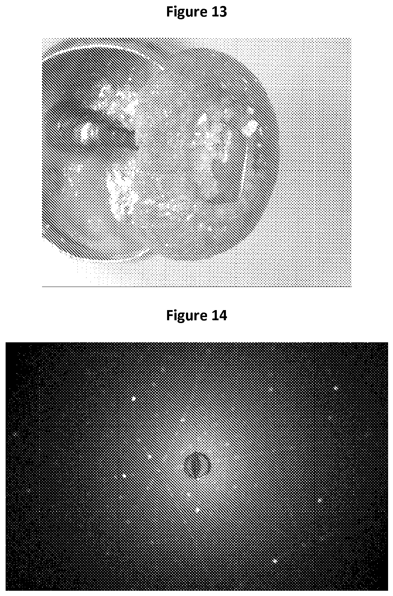

Un agglomérat de monocristaux de Tb₂O₃ a ainsi été obtenu, la photographie de celui-ci est donnée par figure 13 annexée. Sur cette figure, les cristaux de Tb₂O₃ ont été placés sur du papier millimétré (1 carreaux = 1 mm). On constate que les cristaux présentent une taille de l'ordre de quelques millimètres. Par ailleurs, le diagramme de diffraction de Laue obtenu par la méthode de Laue est représenté sur la figure 14 annexée. Les mesures ont été effectuées sur une face naturelle d'un monocristal de Tb₂O₃ orientée (-1-10), sur un goniomètre vendu sous la référence GM WS Series X-Ray par la société Delta Technologies International, en utilisant une anti cathode au molybdène et une caméra CCD de la marque Photonics Science. Ce diagramme est conforme à la structure théorique attendue et confirme la structure cubique d'un des monocristaux de Tb₂O₃ obtenu.

## Revendications

1. Procédé de préparation d'un monocristal massif ou en couche mince constitué d'une matrice d'un sesquioxyde cubique de scandium, d'yttrium et/ou de terre rare, ladite matrice étant dopée ou non par au moins un élément de la série des lanthanides, ledit monocristal répondant à la formule (I) suivante :
(R¹₁₋ₓR²ₓ)₂O₃ (I)
dans laquelle :
- R¹ est au moins un métal de valence III choisi parmi le scandium, l'yttrium et les éléments de la série des lanthanides ;
- x est tel que 0 ≤ x < 1
- R² représente au moins un élément choisi dans la série des lanthanides ;
ledit procédé étant **caractérisé en ce qu'**il est réalisé dans un creuset inerte chimiquement et qu'il comprend les étapes suivantes consistant à :
1) préparer, un mélange pulvérulent (MP1) comprenant au moins :
- un soluté constitué d'au moins un sesquioxyde de formule (IIa) suivante : R'¹₂O₃ (IIa) dans laquelle R'¹ représente le même élément que R¹ et, lorsque ladite matrice est dopée par au moins un élément de la série des lanthanides, d'au moins un sesquioxyde de formule (IIb) suivante : R'²₂O₃ (IIb) dans laquelle R'² représente le même élément que R², en un pourcentage molaire (Xₚₘ) tel que 0 < Xₚₘ ≤ 25 % molaire, étant entendu que ledit sesquioxyde de formule (IIa) est alors présent au sein dudit soluté en un pourcentage molaire (100-Xₚₘ), ledit soluté étant présent au sein du mélange MP1 en une quantité z telle que 0 < z ≤ 93 % molaire,
- un solvant primaire constitué d'un mélange mécanique d'un composé de formule (III) suivante :
[Li₆(R''¹_{1-x'}R''²_{x'})(BO₃)₃] (III)
dans laquelle R"¹ et R"² représentent respectivement le même élément que R¹ et R² et x' est tel que 0 ≤ x' < 1 ;
2) préparer un mélange pulvérulent MP2 comprenant ledit soluté et un solvant de synthèse de formule (IV) suivante :
[Li₆(R"¹₁₋ₓR"²_{x'})(BO₃)₃] + (Li₂O et/ou B₂O₃ et/ou LiX) (IV)
dans laquelle R"¹ et R"² représentent respectivement le même élément que R¹ et R² x' est tel que 0 ≤ x' < 1, et X = F, Cl, Br ou I, par ajout au mélange MP1 d'au moins un additif pulvérulent choisi parmi Li₂O, B₂O₃ et LiX avec X = F, Cl, Br ou I, ledit mélange MP1 étant présent au sein du mélange MP2 en une quantité z' telle que 15 ≤ z' < 100 % molaire, ledit additif étant présent au sein du mélange MP2 en une quantité molaire totale s telles que 0 < s ≤ 85 % molaire, et s = 100-z' dans le mélange MP2 ; la quantité molaire z" du soluté au sein du mélange MP2 étant telle que z"=z.z' ;
3) porter le mélange pulvérulent MP2 obtenu ci-dessus à l'étape 2), à une température T_{MP2} au moins égale à la température de fusion (T_{F}) dudit mélange MP2 et ≤ 1250°C, pour entraîner la dissolution du soluté dans le solvant de synthèse de formule (IV) et obtenir une solution liquide dudit soluté dans le solvant de synthèse de formule (IV) ;
4) maintenir la température de la solution liquide à la température T_{MP2} pendant une durée d'au moins 6 heures, sous agitation au moyen d'un support solide soumis à une rotation autour d'un axe vertical ;
5) refroidir de façon contrôlée la solution liquide depuis la température T_{MP2} jusqu'à une température T_{Exp} comprise entre la température de saturation (T_{Sat}) de la solution liquide et la température de sursaturation critique (TC_{Sur}) de la solution liquide ou de la prise en masse de la solution liquide, pour engendrer la cristallisation contrôlée du sesquioxyde de formule (I) attendu sur ledit support solide immergé dans ladite solution liquide et soumis à une rotation autour d'un axe vertical, ledit refroidissement étant opéré à une vitesse maximale de 1°C.h⁻¹ ;
6) retirer le support solide de la solution liquide puis à refroidir de façon contrôlée le sesquioxyde de formule (I) cristallisé sur le support solide depuis la température T_{Exp} jusqu'à la température ambiante, à une vitesse maximale de 50°C.h⁻¹.

2. Procédé selon la revendication 1, **caractérisé en ce que** les étapes 1) et 2) sont réalisées conjointement, la quantité molaire (z") du soluté au sein du mélange MP2 étant alors telle que z"=z.z'% molaire, la quantité molaire du solvant primaire de formule (III) (t) étant telle que t=z'(100-z)% molaire et la quantité molaire en additif étant de s% molaire, avec s=(100-z')%.

3. Procédé selon la revendication 1 ou 2, **caractérisé en ce que** R¹ est choisi parmi les éléments Y, Gd, Tb, Eu, Sc et Lu et les combinaisons d'éléments Y/Gd, Y/Sc, Gd/Sc, Lu/Sc, Gd/La, Gd/Tb, Gd/Lu, Y/Lu, Eu/Gd, Eu/La et Eu/Lu.

4. Procédé selon l'une quelconque des revendications précédentes, **caractérisé en ce que** lorsque x > 0, R² est choisi parmi les éléments Yb, Tm, Er, Pr, Tb, Nd, Ce, Ho, Eu, Sm et Dy et les combinaisons d'éléments Yb/Tm, Yb/Pr, Tm/Ho, Er/Yb, Yb/Tb, Yb/Ho, Eu/Sm et Tm/Tb.

5. Procédé selon l'une quelconque des revendications précédentes, **caractérisé en ce qu'**il est mis en oeuvre pour la préparation de sesquioxydes de formule (I) choisis parmi :
Tb₂O₃ ; Gd₂O₃ ; Eu₂O₃ ; Y₂O₃ ; Lu₂O₃ ; Sc₂O₃ , (Tb,Gd)₂O₃ ; (Eu,Gd)₂O₃, Lu₂O₃:Yb ; Gd₂O₃:Yb ; Lu₂O₃:Eu ; Gd₂O₃:Eu ; Y₂O₃:Eu ; Y₂O₃:Er ; Gd₂O₃:Tm ; Gd₂O₃:Eu³⁺, (Y,Gd)₂O₃:Pr ; (Y,Gd)₂O₃:Eu ; (Y,Gd)₂O₃:Nd ; (Y,La)₂O₃:Pr ; (Gd,La)₂O₃:Pr ; (Gd,La)₂O₃:Yb ; (Gd,La)₂O₃:Eu ; (Gd,La)₂O₃:Nd ; (Y,La)₂O₃:Yb ; Y₂O₃:Er:Yb ; Y₂O₃:Pr:Yb ; Gd₂O₃:Er:Yb ; Gd₂O₃:Pr:Yb ; Gd₂O₃:Tm:Yb ; Lu₂O₃:Tm:Yb ; Y₂O₃:Tm:Ho ; Y₂O₃:Tm:Yb ; Y₂O₃:Tm:Tb ; Sc₂O₃:Eu ; (Y,Lu)₂O₃:Eu et (Gd,Lu)₂O₃:Eu

6. Procédé selon l'une quelconque des revendications précédentes, **caractérisé en ce que** la quantité z" de soluté présente au sein du mélange pulvérulent MP2 est telle que 5 ≤ z" ≤ 30 % molaire.

7. Procédé selon l'une quelconque des revendications précédentes, **caractérisé en ce que** la quantité s de Li₂O et/ou de B₂O₃ et/ou de LiX présente au sein du mélange pulvérulent MP2 est telle que 5 ≤ s ≤ 30 % molaire.

8. Procédé selon l'une quelconque des revendications précédentes, **caractérisé en ce que** Xₚₘ = 0 ou 0 < Xₚₘ ≤ 10 % molaire.

9. Procédé selon l'une quelconque des revendications précédentes, **caractérisé en ce que** le mélange pulvérulent MP2 réalisé lors des étapes 1) et 2), et comprenant le soluté constitué d'un sesquioxyde de formule (IIa) en mélange ou non avec un sesquioxyde de formule (IIb) et le solvant de synthèse de formule (IV), est préparé selon un procédé comportant les sous-étapes consistant à :
i) préparer, par broyage mécanique, un mélange pulvérulent comprenant 6 moles de Li₂CO₃, 6 moles de H₃BO₃, 1+z moles d'un sesquioxyde de formule (IIa) ou d'un mélange d'un sesquioxyde de formule (IIa) et d'un sesquioxyde de formule (IIb), auquel on ajoute un excès de 20% molaire d'au moins un additif choisi parmi Li₂O (sous forme de Li₂CO₃), B₂O₃ (sous forme de H₃BO₃) et LiX avec X = F, Cl, Br ou I ;
ii) à soumettre le mélange obtenu ci-dessus à l'étape i) à un traitement thermique comprenant :
- une montée en température jusqu'à une température T1 de 400 à 500°C, selon une rampe de montée en température de 120 à 180°C.h⁻¹,
- un palier de maintien de la température T1 pendant 6 à 24 heures,
- une montée en température jusqu'à une température T2 de 700 à 800°C, selon une rampe de montée en température de 120 à 180°C.h⁻¹,
- un palier de maintien de la température T2 pendant 6 à 24 heures,
- une remise à température ambiante avec une rampe de refroidissement de 120 à 180°C.h⁻¹, pour obtenir un matériau solide sous forme de particules, ledit matériau étant constitué du solvant de synthèse de formule (IV) en mélange avec z" % molaire de soluté ;
iii) à broyer mécaniquement le matériau solide obtenu ci-dessus à l'étape ii) pour obtenir le mélange pulvérulent MP2.

10. Procédé selon l'une quelconque des revendications précédentes, **caractérisé en ce que** lors de l'étape 3), la température T_{MP2} est de 1200°C à 1250°C et la vitesse à laquelle le mélange MP2 est porté à la température T_{MP2} est de 120°C.h⁻¹.

11. Procédé selon l'une quelconque des revendications précédentes, **caractérisé en ce que** lors de l'étape 5), la température TC_{Sur} est de 1100°C et le refroidissement contrôlé de la solution liquide depuis la température T_{MP2} jusqu'à une température T_{Exp} est réalisé à une vitesse de 0,1 à 1°C.h⁻¹.

12. Procédé selon l'une quelconque des revendications précédentes, **caractérisé en ce que** lors des étapes 4) et 5), la vitesse de rotation du support solide varie de 5 à 50 tours/min.

13. Procédé selon l'une quelconque des revendications précédentes, **caractérisé en ce que** le refroidissement de l'étape 5) est effectué à une vitesse de 0,2°C.h⁻¹ depuis la température T_{MP2} jusqu'à une température TC_{Sur} de 1100°C, après extraction du support en dehors du liquide et positionnement de celui-ci au dessus de la solution liquide, puis la température de 1100°C est maintenue pendant une durée de moins de 1 heure avant de procéder au refroidissement mentionné à l'étape 6).

14. Procédé selon l'une quelconque des revendications 1 à 12, **caractérisé en ce que** le refroidissement de l'étape 5) est un traitement thermique comportant une alternance d'étapes de refroidissement et d'étapes de remontée en température dans lequel l'amplitude de chaque étape de remontée en température est inférieure ou égale à l'amplitude de l'étape de refroidissement qui la précède.

15. Procédé selon la revendication 14, **caractérisé en ce que** la vitesse de refroidissement varie de préférence de 0,1 à 0,2°C.h⁻¹ et le refroidissement de l'étape 5) est effectué selon le traitement thermique suivant :
Température de départ : 1200°C
i) rampe de 0,2°C.h⁻¹ jusqu'à 1175°C,
ii) rampe de 180°C.h⁻¹ jusqu'à 1190°C,
iii) rampe de 0,2°C.h⁻¹ jusqu'à 1150°C,
iv) rampe de 180°C.h⁻¹ jusqu'à 1165°C,
v) rampe de 0,2°C.h⁻¹ jusqu'à 1125°C,
vi) rampe de 180°C.h⁻¹ jusqu'à 1140°C,
vii) rampe de 0,2°C.h⁻¹ jusqu'à 1100°C,
viii) rampe de 180°C.h⁻¹ jusqu'à 1115°C,
ix) rampe de 0,2°C.h⁻¹ jusqu'à 1100°C.

16. Procédé selon la revendication 14 ou 15, **caractérisé en ce que** le refroidissement de l'étape 6) est réalisé à une vitesse de 5°C.h⁻¹ jusqu'à 800°C puis de 30°C.h⁻¹ jusqu'à la température ambiante.

## Patentansprüche

1. Verfahren zur Herstellung eines massiven oder dünnschichtigen Einkristalls, bestehend aus einer Matrix eines kubischen Sesquioxids aus Scandium, Yttrium und/oder Seltenerde, wobei die Matrix mit mindestens einem Element der Reihe der Lanthanide dotiert ist, wobei das Einkristall der folgenden Formel (I) ist:
(R¹₁₋ₓR²ₓ)₂O₃ (I)
wobei:
- R¹ mindestens ein Metall der Valenz III ist, ausgewählt aus Scandium, Yttrium und den Elementen der Reihe der Lanthanide;
- x wie 0 ≤ x < 1 ist
- R² mindestens ein Element darstellt, ausgewählt aus der Reihe der Lanthanide;
wobei der Prozess **dadurch gekennzeichnet ist, dass** er in einem chemisch inerten Tiegel durchgeführt wird, und dass er die folgenden Schritte umfasst, bestehend aus:
1) Herstellen einer pulverförmigen Mischung (MP1), umfassend mindestens:
- einen gelösten Stoff, der aus mindestens einem Sesquioxid der folgenden Formel (IIa) besteht: R'¹₂O₃ (IIa), wobei R'¹ das gleiche Element wie R¹ darstellt und, wenn die Matrix mit mindestens einem Element der Reihe der Lanthanide dotiert ist, mindestens einem Sesquioxid der folgenden Formel (IIb): R'²₂O₃ (IIb) wobei R'² das gleiche Element wie R² darstellt, mit einem Molprozentsatz (Xₚₘ) wie 0 < Xₚₘ ≤ 25 Molprozent, vorausgesetzt, dass das Sesquioxid der Formel (IIa) dann in dem gelösten Stoff mit einem Molprozentsatz (100-Xₚₘ) vorhanden ist, wobei der gelöste Stoff in der Mischung MP1 in einer Menge z wie 0 < z ≤ 93 Molprozent vorhanden ist,
- ein primäres Lösemittel, das aus einer mechanischen Mischung einer Verbindung der folgenden Formel (III) besteht:
[Li₆(R"¹_{1-x'}R"²_{x'})(BO₃)₃] (III)
wobei R"¹ et R"² jeweils das gleiche Element wie R¹ und R² darstellen und x' wie 0 ≤ x' < 1 ist;
2) Herstellen einer pulverförmigen Mischung MP2, umfassend den gelösten Stoff und ein Syntheselösemittel der folgenden Formel (IV):
[Li₆(R"¹_{1-x'}R"²_{x'})(BO₃)₃] + (Li₂O und/oder B₂O₃ und/oder LiX) (IV)
wobei R"¹ und R"² jeweils das gleiche Element wie R¹ und R² darstellen x' wie 0 ≤ x' < 1 ist und X = F, Cl, Br oder I, durch Zugabe zur Mischung MP1 von mindestens einem pulverförmigen Zusatz, ausgewählt aus Li₂O, B₂O₃ und LiX mit X = F, Cl, Br oder I, wobei die Mischung MP1 in der Mischung MP2 in einer Menge z' wie 15 ≤ z' < 100 Molprozent vorhanden ist, wobei der Zusatz in der Mischung MP2 in einer gesamten Molmenge s wie 0 < s ≤ 85 Molprozent vorhanden ist, und s = 100-z' in der Mischung MP2; wobei die Molmenge z" des gelösten Stoffs in der Mischung MP2 wie z".z.z' ist;
3) Bringen der pulverförmigen Mischung MP2, erhalten oben in Schritt 2), auf eine Temperatur T_{MP2}, die mindestens gleich der Fusionstemperatur (T_{F}) der Mischung MP2 und ≤ 1250 °C ist, um die Lösung des gelösten Stoffs in das Syntheselösemittel der Formel (IV) zu leiten und eine flüssige Lösung des gelösten Stoffs im Syntheselösemittel der Formel (IV) zu erhalten;
4) Beibehalten der Temperatur der flüssigen Lösung bei der Temperatur T_{MP2} während einer Dauer von mindestens 6 Stunden unter Rühren mit Hilfe eines festen Trägers, die einer Drehung um eine vertikale Achse unterzogen wird;
5) Abkühlen, auf kontrollierte Weise, der flüssigen Lösung von der Temperatur T_{M}p₂ auf die Temperatur T_{Exp}, die zwischen der Sättigungstemperatur (T_{Sat}) der flüssigen Lösung und der kritischen Sättigungstemperatur (TC_{Sur}) der flüssigen Lösung oder des Verklumpens der flüssigen Lösung liegt, um die kontrollierte Kristallisierung des Sesquioxids der Formel (I) zu verursachen, die auf dem festen Träger erwartet wird, der in die flüssige Lösung eingetaucht und einer Drehung um eine vertikale Achse unterzogen wird, wobei die Abkühlung mit einer maximalen Geschwindigkeit von 1 °C.h⁻¹ durchgeführt wird;
6) Rückziehen des festen Trägers aus der flüssigen Lösung, dann Abkühlen, auf kontrollierte Weise, des Sesquioxids der Formel (I), kritstallisiert auf dem festen Träger, von der Temperatur T_{Exp} bis zur Raumtemperatur, mit einer maximalen Geschwindigkeit von 50 °C.h⁻¹.

2. Verfahren nach Anspruch 1, **dadurch gekennzeichnet, dass** die Schritte 1) und 2) zusammen durchgeführt werden, wobei die Molmenge (z") des gelösten Stoffs in der Mischung MP2 dann wie z"=z.z' Molprozent ist, wobei die Molmenge des primären Lösemittels der Formel (III) (t) wie t=z'(100-z) Molprozent ist und die Molmenge an Zusatz s Molprozent mit s = (100-z')% ist.

3. Verfahren nach Anspruch 1 oder 2, **dadurch gekennzeichnet, dass** R¹ ausgewählt ist aus den Elementen Y, Gd, Tb, Eu, Sc und Lu und den Kombinationen von Elementen Y/Gd, Y/Sc, Gd/Sc, Lu/Sc, Gd/La, Gd/Tb, Gd/Lu, Y/Lu, Eu/Gd, Eu/La und Eu/Lu.

4. Verfahren nach einem beliebigen der vorhergehenden Ansprüche, **dadurch gekennzeichnet, dass**, wenn x > 0, R² ausgewählt ist aus den Elementen Yb, Tm, Er, Pr, Tb, Nd, Ce, Ho, Eu, Sm und Dy und den Kombinationen von Elementen Yb/Tm, Yb/Pr, Tm/Ho, Er/Yb, Yb/Tb, Yb/Ho, Eu/Sm und Tm/Tb.

5. Verfahren nach einem beliebigen der vorhergehenden Ansprüche, **dadurch gekennzeichnet, dass** es durchgeführt wird für die Herstellung von Sesquioxiden der Formel (I), ausgewählt aus:
Tb₂O₃; Gd₂O₃; Eu₂O₃; Y₂O₃; Lu₂O₃; SC₂O₃; (Tb,Gd)₂O₃; (Eu,Gd)₂O₃, Lu₂O₃:Yb; Gd₂O₃:Yb; Lu₂O₃:Eu; Gd₂O₃:Eu; Y₂O₃:Eu; Y₂O₃:Er; Gd₂O₃:Tm; Gd₂O₃:Eu³⁺, (Y,Gd)₂O₃:Pr; (Y,Gd)₂O₃:Eu; (Y,Gd)₂O₃:Nd; (Y,La)₂O₃:Pr; (Gd,La)₂O₃:Pr; (Gd,La)₂O₃:Yb; (Gd,La)₂O₃:Eu; (Gd,La)₂O₃:Nd; (Y,La)₂O₃:Yb; Y₂O₃:Er:Yb; Y₂O₃:Pr:Yb; Gd₂O₃:Er:Yb; Gd₂O₃:Pr:Yb; Gd₂O₃:Tm:Yb; Lu₂O₃:Tm:Yb; Y₂O₃:Tm:Ho; Y₂O₃:Tm:Yb; Y₂O₃:Tm:Tb; Sc₂O₃:Eu; (Y,Lu)₂O₃:Eu und (Gd,Lu)₂O₃:Eu

6. Verfahren nach einem beliebigen der vorhergehenden Ansprüche, **dadurch gekennzeichnet, dass**, die Menge z" des gelösten Stoffs in der pulverförmigen Mischung MP2 derart ist, dass 5 ≤ z" ≤ 30 Molprozent.

7. Verfahren nach einem beliebigen der vorhergehenden Ansprüche, **dadurch gekennzeichnet, dass**, die Menge s von Li₂O und/oder von B₂O₃ und/oder von LiX, die in der pulverförmigen Mischung MP2 vorhanden ist, wie 5 ≤ s ≤ 30 Molprozent.

8. Verfahren nach einem beliebigen der vorhergehenden Ansprüche, **dadurch gekennzeichnet, dass**, Xₚₘ = 0 ou 0 < Xₚₘ ≤ 10 Molprozent.

9. Verfahren nach einem beliebigen der vorhergehenden Ansprüche, **dadurch gekennzeichnet, dass** die pulverförmige Mischung MP2, durchgeführt in Schritt 1) und 2) und umfassend den gelösten Stoff, bestehend aus einem Sesquioxid der Formel (IIa) in Mischung oder nicht mit einem Sesquioxid der Formel (IIb) und dem Syntheselösemittel der Formel (IV) gemäß einem Verfahren hergestellt wird, umfassend die Unterschritte, bestehend aus:
i) Herstellen, durch mechanisches Mahlen, einer pulverförmigen Mischung, umfassend 6 Mol Li₂CO₃, 6 Mol H₃BO₃, 1+z Mol eines Sesquioxids der Formel (IIa) oder einer Mischung eines Sesquioxids der Formel (IIa) und eines Sesquioxids der Formel (IIb), der ein Überschuss von 20 Molprozent mindestens eines Zusatzes zugegeben wird, ausgewählt aus Li₂O (in Form von Li₂CO₃), B₂O₃ (in Form von H₃BO₃) und LiX mit X = F, Cl, Br oder I;
ii) Unterziehen der oben in Schritt i) erhaltenen Mischung einer thermischen Behandlung, umfassend:
- einen Temperaturanstieg bis zu einer Temperatur T1 von 400 bis 500°C gemäß einer Temperaturanstiegsrampe von 120 bis 180°C.h⁻¹,
- eine Phase der Beibehaltung der Temperatur T1 während 6 bis 24 Stunden,
- einen Temperaturanstieg bis zu einer Temperatur T2 von 700 bis 800°C, gemäß einer Temperaturanstiegsrampe von 120 bis 180°C.h⁻¹,
- eine Phase der Beibehaltung der Temperatur T2 während 6 bis 24 Stunden,
- eine Rückstellung auf Raumtemperatur mit einer Abkühlungsrampe von 120 bis 180°C.h⁻¹, um ein festes Material in Form von Partikeln zu erhalten, wobei das Material aus Syntheselösemittel der Formel (IV) in Mischung mit z" Molprozent gelöstem Stoff besteht;
iii) mechanisches Malen des festen Materials, erhalten oben in Schritt ii), um eine pulverförmige Mischung MP2 zu erhalten.

10. Verfahren nach einem beliebigen der vorhergehenden Ansprüche, **dadurch gekennzeichnet, dass** in Schritt 3) die Temperatur T_{MP2} von 1200 °C bis 1250 °C ist und die Geschwindigkeit, mit der die Mischung MP2 auf die Temperatur T_{MP2} gebracht wird, 120 °C.h⁻¹ beträgt.

11. Verfahren nach einem beliebigen der vorhergehenden Ansprüche, **dadurch gekennzeichnet, dass** in Schritt 5) die Temperatur TC_{Sur} 1100 °C ist und die kontrollierte Abkühlung der flüssigen Lösung von der Temperatur T_{MP2} bis zu einer Temperatur T_{Exp} mit einer Geschwindigkeit von 0,1 bis 1 °C.h¹ durchgeführt wird.

12. Verfahren nach einem beliebigen der vorhergehenden Ansprüche, **dadurch gekennzeichnet, dass** in Schritt 4) und 5) die Drehgeschwindigkeit des festen Trägers von 5 bis 50 U/min variiert.

13. Verfahren nach einem beliebigen der vorhergehenden Ansprüche, **dadurch gekennzeichnet, dass** die Abkühlung von Schritt 5) mit einer Geschwindigkeit von 0,2 °C.h⁻¹ von der Temperatur T_{MP2} zu einer Temperatur TCₛᵤᵣ von 1100 °C nach einer Extraktion des Trägers aus der Flüssigkeit und Positionierung dieser über die flüssige Lösung durchgeführt wird, dann die Temperatur von 1100 °C während einer Dauer von weniger als 1 Stunde beibehalten wird, bevor mit der erwähnten Abkühlung, erwähnt in Schritt 6), fortgefahren wird.

14. Verfahren nach einem beliebigen der Ansprüche 1 bis 12, **dadurch gekennzeichnet, dass** die Abkühlung von Schritt 5) eine thermische Behandlung ist, umfassend eine Abfolge von Schritten des Abkühlens und Schritten des Ansteigens der Temperatur, wobei die Amplitude jedes Schritts des Ansteigens der Temperatur geringer als oder gleich wie die Amplitude des Schritts des Abkühlens ist, der ihm vorausgeht.

15. Verfahren nach Anspruch 14, **dadurch gekennzeichnet, dass** die Geschwindigkeit der Abkühlung vorzugsweise von 0,1 bis 0,2 °C.h⁻¹ variiert und die Abkühlung von Schritt 5) gemäß der folgenden thermischen Behandlung durchgeführt wird:
Ausgangstemperatur: 1200 °C
i) Rampe von de 0,2 °C.h⁻¹ bis 1175 °C,
ii) Rampe von 180 °C.h⁻¹ bis 1190 °C,
iii) Rampe von 0,2 °C.h⁻¹ bis 1150 °C,
iv) Rampe von180 °C.h⁻¹ bis 1165 °C,
v) Rampe von 0,2 °C.h⁻¹ bis 1125 °C,
vi) Rampe von 180 °C.h⁻¹ bis 1140 °C,
vii) Rampe von 0,2 °C.h⁻¹ bis 1100 °C,
viii) Rampe von 180 °C.h⁻¹ bis 1115 °C,
ix) Rampe von 0,2 °C.h⁻¹ bis 1100 °C.

16. Verfahren nach Anspruch 14 oder 15, **dadurch gekennzeichnet, dass** die Abkühlung von Schritt 6) mit einer Geschwindigkeit von de 5 °C.h⁻¹ bis 800 °C, dann 30 °C.h⁻¹ bis zur Raumtemperatur durchgeführt wird.

## Claims

1. A method for preparing a bulk single crystal or in a thin layer consisting of a matrix of a scandium, yttrium and/or rare earth cubic sesquioxide, said matrix being either doped or not with at least one element from the series of lanthanides, said single crystal fitting the following formula (I) :
(R¹₁₋ₓR²ₓ)₂O₃ (I)
wherein:
- R¹ is at least a metal of valency III selected from among scandium, yttrium and the elements of the series of lanthanides;
- x is such that 0≤x<1;
- R² re-presents at least one element selected from the series of lanthanides;
said method being **characterized in that** it is carried out in a chemically inert crucible and that it comprises the following steps consisting of:
1) preparing a powdery mixture (MP1) comprising at least:
- one solute consisting of at least one sesquioxide of the following formula (IIa) : R'¹₂O₃ wherein R'¹ represents the same element as R¹ and, when said matrix is doped with at least one element of the series of lanthanides, of at least one of sesquioxide of the following formula (IIb) : R'²₂O₃ wherein R'² represents the same element as R², in a molar percentage (xₚₘ) such that 0≤xₚₘ<25molar%, it being understood that said sesquioxide of formula (IIa) is also present within said solute in a molar percentage (100-xₚₘ), said solute being present within the mixture MP1 in an amount z such that 0<z≤93molar%,
- a primary solvent consisting of a mechanical mixture of a compound of the following formula (III):
[Li₆(R"¹_{1-x'} R"²_{x'}) (BO₃)₃] (III)
wherein R"¹ and R"² respectively represent the same elements as R¹ and R² and x' is such that 0≤x'<1;,
2) preparing a powdery mixture MP2 comprising said solute and a synthetic solvent of the following formula (IV):
[Li₆(R"¹_{1-x'} R"²_{x'}) (BO₃)₃] + (Li₂O and/or B₂O₃ and/or LiX) (IV)
wherein R"¹ and R"² respectively represent the same element as R¹ and R², x' is such that 0≤x'<1, and X=F, Cl, Br or I, by adding to the mixture MP1 at least one powdery additive selected from among Li₂O, B₂O₃ and LiX with X = F, Cl, Br or I, said mixture MP1 being present within the mixture MP2 in an amount z' such that 15≤z'<100molar%, said additive being present within the mixture MP2 in a total molar amount s such that 0<s≤85molar%, and s =100-z' in the mixture MP2; the molar amount z" of the solute within the mixture MP2 being such that z"=z.z';
3) bringing the obtained powdery mixture MP2 in step 2), to a temperature T_{MP2} at least equal to the melting temperature (T_{F}) of said mixture MP2 and ≤ 1,250°C, for causing dissolution of the solute into the synthetic solvent of formula (IV) and obtaining a liquid solution of said solute in the synthetic solvent of formula (IV);
4) maintaining the temperature of the liquid solution at the temperature TMP2 for a period of at least 6 hours, with stirring by means of a solid support subject to rotation around a vertical axis;
5) controllably cooling the liquid solution from the temperature T_{MP2} down to a temperature Tₑₓₚ comprised between the saturation temperature (T_{Sat}) of the liquid solution and the critical oversaturation temperature (TCₒᵥₑᵣ) of the liquid solution or of the build-up of the liquid solution, for generating controlled crystallization of the sesquioxide of formula (I) expected on said immersed solid support in said liquid solution and subject to rotation around a vertical axis, said cooling being performed at a maximum rate of 1°C.h⁻¹;
6) removing the solid support from the liquid solution and then controllably cooling the sesquioxide of formula (I) crystallized on the solid support from temperature Tₑₓₚ down to room temperature, at a maximum rate of 50°C.h⁻¹.

2. The method according to claim 1, **characterized in that** the steps 1) and 2) are achieved together, the molar amount (z") of the solute within the mixture MP2 being then such that z"=z.z'molar%, the molar amount of the primary solvent of formula (III) (t) being such that t=z'(100-z)molar% and the additive amount being smolar%, with s=(100-z')%.

3. The method according to claim 1 or 2, **characterized in that** R1 is selected from among the elements Y, Gd, Tb, Eu, Sc and Lu and from the combinations of elements Y/Gd, Y/Sc, Gd/Sc, Lu/Se, Gd/La, Gd/Tb, Gd/Lu, Y/Lu, Eu/Gd, Eu/La and Eu/Lu.

4. The method according to any of the preceding claims, **characterized in that** when x > 0, R² is selected from among Yb, Tm, Er, Pr, Tb, Nd, Ce, Ho, Eu, Sm and Dy and from the combinations of elements Yb/Tm, Yb/Pr, Tm/Ho, Er/Yb, Yb/Tb, Yb/Ho, Eu/Sm and Tm/Tb.

5. The method according to any of the preceding claims, **characterized in that** it is applied for the preparation of sesquioxides of formula (I) selected from among Tb₂O₃; Gd₂O₃; Eu₂O₃; Y₂O₃; Lu₂O₃; SC₂O₃; (Tb, Gd)₂O₃; (Eu, Gd)₂O₃, Lu₂O₃:Yb; Gd₂O₃:Yb; Lu₂O₃:Eu; Gd₂O₃:Eu; Y₂O₃:Eu; Y₂O₃:Er; Gd₂O₃:Tm; Gd₂O₃:Eu³⁺, (Y, Gd)₂O₃:Pr; (Y, Gd)₂O₃:Eu; (Y, Gd)₂O₃:Nd; (Y, La)₂O₃:Pr; (Gd, La)₂O₃:Pr; (Gd, La)₂O₃:Yb; (Gd, La)₂O₃:Eu; (Gd, La)₂O₃:Nd; (Y, La)₂O₃:Yb; Y₂O₃:Er:Yb; Y₂O₃:Pr:Yb; Gd₂O₃:Er:Yb; Gd₂O₃:Pr:Yb; Gd₂O₃:Tm:Yb; Lu₂O₃:Tm:Yb; Y₂O₃:Tm:Ho; Y₂O₃:Tm:Yb; Y₂O₃:Tm:Tb; Sc₂O₃:Eu; (Y,Lu)₂O₃:Eu and (Gd,Lu)₂O₃:Eu.

6. The method according to any of the preceding claims, **characterized in that** the amount z" of solute present within the powdery mixture MP2 is such that 5≤z"<30molar%.

7. The method according to any of the preceding claims, **characterized in that** the amount s of Li₂O and/or B₂O₃ and/or LiX present within the powdery mixture MP2 is such that 5≤s<30molar%.

8. The method according to any of the preceding claims, **characterized in that** xₚₘ = 0 or 0<xₚₘ≤10molar%.

9. The method according to any of the preceding claims, **characterized in that** the powdery mixture MP2 produced during steps 1) and 2), and comprising the solute consisting of a sesquioxide of formula (IIa), either mixed or not with a sesquioxide of formula (IIb) and the synthetic solvent of formula (IV), is prepared according to a method including the sub-steps consisting of:
i) preparing by mechanical milling a powdery mixture comprising 6 moles of Li₂CO₃, 6 moles of H₃BO₃, 1+z moles of a sesquioxide of formula (IIa) or of a mixture of a sesquioxide of formula (IIb) to which is added a 20molar% excess of at least one additive selected from among Li₂O (as Li₂CO₃), B₂O₃ (as H₃BO₃) and LiX with X=F, Cl, Br or I;
ii) subjecting the mixture obtained above in step 1) to a heat treatment comprising:
- a rise in temperature up to a temperature T1 from 400 to 500°C according to a temperature rise ramp from 120 to 180°C.h⁻¹,
- a plateau for maintaining the temperature T1 for 6 to 24 hours,
- a rise in temperature up to a temperature T2 from 700 to 800°C according to a temperature rise ramp from 120 to 180°C.h⁻¹,
- a plateau for maintaining the temperature T2 for 6 to 24 hours,
- a reset to room temperature with a cooling ramp of 120°C to 180°C.h⁻¹, in order to obtain a solid material as particles, said material consisting of the synthetic solvent of formula (IV) mixed with z"molar% of solute;
iii) mechanically milling the solid material obtained above in step ii) for obtaining the powdery mixture MP2.

10. The method according to any of the preceding claims, **characterized in that** during step 3), the temperature T_{MP2} is from 1,200°C to 1,250°C and the rate at which the mixture MP2 is brought to the temperature T_{MP2} is 120°C.h⁻¹.

11. The method according to any of the preceding claims, **characterized in that** during step 5), the temperature TCₒᵥₑᵣ is 1,100°C and the controlled cooling of the liquid solution from the temperature T_{MP2} down to the temperature Tₑₓₚ is achieved at a rate of 0.1 to 1°C.h⁻¹.

12. The method according to any of the preceding claims, **characterized in that**, during steps 4) and 5), the speed of rotation of the solid support varies from 5 revolutions/min to 50 revolutions/min.

13. The method according to any of the preceding claims, **characterized in that** the cooling of step 5) is carried out at a rate of 0.2°C.h⁻¹, from the temperature T_{MP2} down to a temperature TCₒᵥₑᵣ of 1,100°C, after extraction of the support out of the liquid and positioning the latter above the liquid solution, and then the temperature of 1,100°C is maintained for a period of at least 1 hour before proceeding with the cooling mentioned in step 6).

14. The method according to any of claims 1 to 12, **characterized in that** the cooling of step 5) is a heat treatment including an alternation of cooling steps and temperature raising steps wherein the amplitude of each temperature raising step is less than or equal to the amplitude of the cooling step which precedes it.

15. The method according to claim 14, **characterized in that** the cooling rate preferably varies from 0.1 to 0.2°C.h⁻¹ and the cooling of step 5) is carried out according to the following heat treatment:
Initial temperature: 1,200°C
i) ramp of 0.2°C.h⁻¹ up to 1,175°C,
ii) ramp of 180°C.h⁻¹ up to 1,190°C,
iii) ramp of 0,2°C.h⁻¹ up to 1,150°C,
iv) ramp of 180°C.h⁻¹ up to 1,165°C,
v) ramp of 0.2°C.h⁻¹ up to 1,125°C,
vi) ramp of 180°C.h⁻¹ up to 1,140°C,
vii) ramp of 0.2°C.h⁻¹ up to 1,100°C,
viii) ramp of 180°C.h⁻¹ up to 1,115°C,
ix) ramp of 0.2°C.h⁻¹ up to 1,100°C.

16. The method according to claim 14 or 15, **characterized in that** the cooling of step 6) is carried out at a rate of 5°C.h⁻1 from 800°C and then 30°C.h⁻¹ down to room temperature.
